(19) Europäisches Patentamt
European Patent Office
Office européen des brevets

(11) **EP 4 109 121 B1**

(12) **EUROPÄISCHE PATENTSCHRIFT**

(45) Veröffentlichungstag und Bekanntmachung des Hinweises auf die Patenterteilung:
**08.01.2025 Patentblatt 2025/02**

(21) Anmeldenummer: **22180431.3**

(22) Anmeldetag: **22.06.2022**

(51) Internationale Patentklassifikation (IPC):
**G01R 33/38** (2006.01) **G01R 33/3815** (2006.01)
**H01F 6/04** (2006.01)

(52) Gemeinsame Patentklassifikation (CPC):
**G01R 33/3804; G01R 33/3815; H01F 6/04**

(54) **AUTONOMES HERUNTERKÜHLEN EINES SUPRALEITFÄHIGEN, TROCKEN-GEKÜHLTEN MR-MAGNETSPULENSYSTEMS**

AUTONOMOUS COOLING OF A SUPERCONDUCTIVE, DRY COOLED MR MAGNETIC COIL SYSTEM

REFROIDISSEMENT AUTONOME D'UN SYSTÈME SUPRACONDUCTEUR DE BOBINE MAGNÉTIQUE RM À REFROIDISSEMENT À SEC

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **22.06.2021 DE 102021206392**

(43) Veröffentlichungstag der Anmeldung:
**28.12.2022 Patentblatt 2022/52**

(73) Patentinhaber: **Bruker BioSpin GmbH**
**76275 Ettlingen (DE)**

(72) Erfinder: **Strobel, Marco**
**76137 Karlsruhe (DE)**

(74) Vertreter: **Kohler Schmid Möbus Patentanwälte Partnerschaftsgesellschaft mbB**
**Gropiusplatz 10**
**70563 Stuttgart (DE)**

(56) Entgegenhaltungen:
**JP-A- 2020 145 371    US-A1- 2019 212 049**

**Beschreibung**

Die Erfindung betrifft ein Verfahren zum Betrieb einer Magnetresonanz(="MR")-Apparatur mit einem in einem Vakuumbehälter angeordneten, im MR-Messbetrieb trockenen (="Kryogen-freien"), supraleitfähigen MR-Magnetspulensystem sowie mit einem Kryostaten zum Kühlen des MR-Magnetspulensystems, welcher ein Halsrohr umfasst, das durch einen Außenmantel des Vakuumbehälters hindurch zum MR-Magnetspulensystem führt, wobei ein Kühlarm eines Kaltkopfes zumindest teilweise im Halsrohr angeordnet ist, wobei um den Kühlarm herum ein abgeschlossener Hohlraum ausgebildet ist, der gegenüber dem zu kühlenden MR-Magnetspulensystem fluiddicht abgedichtet und im Normalbetrieb der MR-Apparatur zumindest teilweise mit einem kryogenen Fluid gefüllt ist. Die Erfindung betrifft weiter eine MR-Apparatur und eine Kontrolleinheit zur Durchführung des Verfahrens.

Ein solches Verfahren sowie die zugehörige MR-Apparatur sind bekannt geworden aus der US 2019/212049 A1 (=Referenz [0]), welche die Priorität der DE 10 2016 218 000 B3 (=Referenz [1]) in Anspruch nimmt.

Hintergrund der Erfindung

Die vorliegende Erfindung betrifft allgemein den Bereich der Kühlung von supraleitenden Magnetanordnungen, welche im Betrieb auf sehr tiefen (=kryogenen) Temperaturen gehalten werden sollen/müssen. Derartige supraleitenden Magnetanordnungen werden etwa auf dem Gebiet der Magnetresonanz, beispielsweise in MRI(=Magnetic Resonance Imaging)-Tomographen oder NMR(= Nuclear Magnetic Resonance)-Spektrometern eingesetzt.

Die Kernspinresonanz ist ein leistungsfähiges Verfahren der instrumentellen Analytik, mit dem insbesondere die chemische Zusammensetzung von Messproben bestimmt werden kann. Dabei werden Hochfrequenz-Pulse in die Messprobe, die sich in einem starken statischen Magnetfeld befindet, eingestrahlt, und die elektromagnetische Reaktion der Probe wird vermessen. Das starke und in der NMR besonders homogene statische Magnetfeld wird in vielen Fällen mittels supraleitender Magnetsysteme erzeugt, welche im Messbetrieb dazu, zumeist unter Zuhilfenahme von flüssigem Helium als kryogenem Fluid, auf sehr niedrige kryogene Temperaturen nahe dem absoluten Nullpunkt gekühlt werden müssen.

Oftmals werden derartige supraleitende Magnetsysteme auch mit einer aktiven Kühlung ausgerüstet. Die Systeme verfügen dann zumeist über gar keinen Fluidtank mehr, in welchem die Magnete unmittelbar von kryogenem Fluid umgeben sind. Vielmehr sind die Spulen der Magnetsysteme in einem Vakuumbehälter angeordnet und mithin im MR-Messbetrieb "trocken", also Kryogen-frei. In der Regel werden den Vakuumbehälter umgebende Strahlungsschilde, mitunter aber auch die Magnetsysteme direkt von einem aktiven Kühler gekühlt, z.B. von einem Pulsrohr-Kühler oder einem Gifford-Mac-Mahon -Kühler.

Diese trockenen Systeme sind generell anfälliger für Störungen des Kühlsystems, wenn beispielsweise der Kaltkopf ausfällt, denn im Gegensatz zu Bad-gekühlten Magnetsystemen ist kein Temperaturpuffer in Form eines das Magnetsystem unmittelbar umgebenden, in der Regel flüssigen Kryogens vorhanden, das bei Ausfall des Kühlsystems abdampfen kann und somit über einen längeren Zeitraum die kryogene Temperatur beibehält. Hingegen erfordern diese Bad-gekühlten Systeme bei der Inbetriebnahme einen größeren Personalaufwand sowie höhere Kosten, weil zum Abkühlen und Befüllen große Mengen (bis zu mehrere 1000 Liter) flüssiges Helium und Stickstoff verwendet werden, welche im Falle eines Quenches erneut nachgefüllt werden müssen. Demgemäß können Bad-gekühlte Systeme niemals autark betrieben werden. Die Verwendung aktiver Kühlsysteme reduziert insbesondere den Verbrauch an teurem flüssigem Helium, erhöht die Verfügbarkeit der NMR-Apparatur und kann auch zur Reduktion der Bauhöhe beitragen. Das aktive Kühlsystem kann einstufig oder auch mehrstufig ausgebildet sein. Bei mehrstufigen Systemen kühlt meist eine wärmere Kaltstufe den thermischen Strahlungsschild und eine kältere Kaltstufe das zu kühlende Objekt.

Spezieller Stand der Technik

Die DE 20 2017 001 501 U1 (=Referenz [2]) beschreibt eine Überwachungsvorrichtung für das Gradientensystem einer MR-Apparatur, um den sicheren Betrieb der Magnetspulen zu gewährleisten. Die Vorrichtung umfasst einen Temperatursensor, der die Temperatur-Messergebnisse an eine Sicherungseinheit weiterleitet. Die Sicherungseinheit initiiert in der Folge verschiedene Aktionen, wie z.B. Ausgabe von Warnungen an den Benutzer, Unterbrechung des Betriebs oder Änderung von Parametern und Reihenfolge von Messsequenzen. Des Weiteren ist ein Kühlsystem vorgesehen, mit welchem die Elemente (Leistungsverstärker) des Gradientensystems aktiv gekühlt werden kann. Ein supraleitendes Magnetsystem, das autark auf kryogene Temperaturen gebracht werden kann, ist in Referenz [2] weder beschrieben noch angedeutet.

Die EP 3 454 071 A1 (=Referenz [3]) beschreibt ein Verfahren zur Überwachung der Funktion eines Kühlsystems einer MR-Einrichtung. An verschiedenen der Komponenten bzw. diesen zugeordnet sind als Teil der Magnetresonanzeinrichtung Temperatursensoren vorgesehen, welche als Messdaten entsprechende Temperaturwerte liefern. Die Magnetresonanzeinrichtung umfasst ein vorliegend Wasser als Kühlmittel nutzendes Kühlsystem, welches zur Kühlung zu kühlender Komponenten in verschiedenen Kühlzweigen, in denen Komponenten seriell gekühlt werden können, verwendet wird.

Es können auch Flusssensoren verwendet werden. Die Daten der Sensoren werden abgeglichen mit Vergleichsgrößen und ausgewertet, um entsprechende Maßnahmen durchzuführen. Ein -insbesondere autarkes-Herunterkühlen eines Supraleiters auf kryogene Temperaturen ist in Referenz [3] nicht offenbart.

Die US 8 729 894 B2 (=Referenz [4]) offenbart ein Magnetsystem für die MRI, umfassend einen Behälter mit flüssigem Kryogen darin, sowie einen supraleitenden Magneten innerhalb des Behälters, wobei der Behälter so konfiguriert ist, dass er abnehmbar mit einer Vakuumpumpe verbunden ist, welche ihrerseits so konfiguriert ist, dass sie Kryogen aus dem Behälter pumpt, um ein Druckniveau innerhalb des Behälters während des Hochfahrens des supraleitenden Magneten auf ein abgepumptes Druckniveau zu reduzieren und das Druckniveau von dem abgepumpten Druckniveau auf ein normales Betriebsdruckniveau zu erhöhen Druckniveau während des normalen Magnetbetriebs zu erhöhen. Referenz [4] beschreibt weiterhin ein Verfahren zum Laden des Magneten, wobei während des sogenannten Rampings der Behälter mit dem Magneten evakuiert werden kann. Ein Kaltkopf ist in einem Halsrohr angeordnet, ohne das Vakuum im Behälter zu beeinflussen. Allerdings ist bei dieser Anordnung das Halsrohr nicht mit Kryogen gefüllt, sondern der Kryostat enthält flüssiges Helium. Hinsichtlich der vorliegenden Erfindung bildet Referenz [4] fernerliegenden Stand der Technik, da es sich um ein "nass gekühltes" Spulensystem handelt, bei welchem die unten beschriebenen erfindungsgemäßen Maßnahmen gar nicht durchführbar wären und somit ein autarker Betrieb ausgeschlossen ist.

Die US 2006 0225433 A1 (=Referenz [5]) beschreibt ein Monitoring-System zur Vorhersage von Komponentenausfällen. Der MRI Scanner umfasst einen Bad-gekühlten Magneten. Zur Überwachung des Betriebs des Scanners ist eine Vielzahl von Sensoren vorgesehen. In der dargestellten Ausführungsform sind Sensoren im Inneren des Kryostaten vorgesehen, um die Temperatur und den Druck des Behälters zu überwachen. Andere Sensoren können zur Überwachung der Kühlkomponenten des Kühlsystems, wie z. B. des Kaltkopfs und des Kompressors etc. vorgesehen sein. Die Sensoren liefern Daten über den Betrieb des Scanners an die Überwachungsschaltung. Die Überwachungsschaltung umfasst ferner eine Zwischendatenbank und einen Algorithmus sowie einen Prozessor. Die Zwischendatenbank ist so konfiguriert, dass sie Daten in Bezug auf den Betrieb des Scanners speichert. Der Algorithmus ist in Zusammenarbeit mit dem Prozessor so konfiguriert, dass er verschiedene Berechnungs- und Verarbeitungsoperationen der in der Zwischendatenbank gespeicherten Daten durchführt. Die abgeglichenen Daten werden an eine Benutzerschnittstelle übertragen. Mit diesem Bad-gekühlten System ist ein autonomes Herunterkühlen des Kryostaten nicht möglich, da die Überwachungsschaltung keine Informationen an Steuerelemente für Pumpen etc. weitergibt. Hinsichtlich der vorliegenden Erfindung bildet Referenz [5] ebenso wie Referenz [4] lediglich fernerliegenden Stand der Technik.

Aus der DE 10 2014 218 773 B4 (=Referenz [6]) ist es bekannt, bei einem Kryostaten ein Hohlvolumen zwischen der Innenseite des Halsrohrs und dem Kühlarm eines Kühlkopfes mit einem Gas, etwa Helium, zu füllen. Im Normalbetrieb befindet sich die unterste Kühlstufe des Kühlarms nahe dem zu kühlenden Objekt; beispielsweise wird eine enge thermische Kopplung über einen Kontakt des zu kühlenden Objekts und der untersten Kühlstufe zu einer geringen Menge flüssigen Heliums im Hohlvolumen hergestellt. Bei Ausfall der Kühlung steigt der Gasdruck im Hohlvolumen in Folge der Erwärmung an; etwaiges flüssiges Helium im Hohlvolumen verdampft. Der verschiebbar gelagerte Kühlkopf wird durch den gestiegenen Gasdruck im Hohlvolumen in Richtung vom zu kühlenden Objekt weg bewegt, wodurch die thermische Kopplung von Kühlarm und zu kühlendem Objekt verringert wird. Mit diesem Kryostaten kann die Wärmelast durch einen Kühlarm bei Ausfall der aktiven Kühlung verringert werden, jedoch ist der bauliche Aufwand durch die verfahrbare Aufhängung des Kaltkopfs vergleichsweise groß. Zudem bleibt aufgrund des hohen Gasdrucks im Hohlvolumen weiterhin eine nicht unerhebliche thermische Kopplung bestehen.

Die DE 10 2015 215 919 B4 (= Referenz [7]) beschreibt ein Verfahren und eine Vorrichtung zur Vorkühlung eines Kryostaten mit Heatpipe, wie er etwa in Referenz [6] gezeigt ist. Während einer Vorkühlphase wird das zu kühlende Objekt auf eine Zieltemperatur des Arbeitsbereichs des kryogenen Arbeitsmediums vorgekühlt, in welchem die Heatpipe effizient arbeiten kann, wobei zur Vorkühlung ein gut wärmeleitender, passgenauer Kurzschlussblock durch das Halsrohr in die Heatpipe gesteckt wird, dessen eines freies Ende thermisch mit einer leistungsstarken Kühleinrichtung verbunden ist, dessen anderes Ende die thermische Kontaktfläche berührt. In einer Zwischenphase nach Erreichen der Zieltemperatur wird der Kurzschlussblock aus der Heatpipe entfernt und anschließend während einer Betriebsphase durch die Heatpipe im Kondensationsbetrieb Wärme übertragen. Damit kann die erforderliche Zeit zur Vorkühlung des Kryostaten auf seine Betriebstemperatur signifikant reduziert werden, um so die Dauer der Inbetriebnahme wesentlich zu verkürzen.

Die JP 2020 145371 A (= Referenz [8]) beschreibt ein Verfahren zum Wiederstart einer supraleitenden Magnetanordnung mit evakuierbarem Kryostat in einem Cyclotron. Es sollen die Temperatur eines mit einem Refrigerator gekühlten Teiles oder der Druck im Kryostaten gemessen werden, um daraus auf eine eventuelle Verschlechterung durch eine Erhöhung der Kryostatentemperatur oder einen Anstieg des Kryostatendrucks zu schließen. Eine Kontrolleinheit soll dann mit einem Outputsignal an ein Pumpsystem zum Auspumpen des Kryostaten reagieren.

Die bereits eingangs zitierten Referenzen [0] und [1] beschreiben eine Kryostatenanordnung mit einem Vakuumbehälter und einem Kühlobjekt, das innerhalb des Vakuumbehälters angeordnet ist, welcher ein Halsrohr aufweist, das zum Kühlobjekt führt, wobei ein Kühlarm eines Kaltkopfs, um den herum ein abgeschlossener Hohlraum ausgebildet ist, im Halsrohr angeordnet ist, der gegenüber dem Kühlobjekt fluiddicht abgedichtet und im Normalbetrieb mit kryogenem Fluid gefüllt ist. Ein derartiger Kryostat kann zur Durchführung des generischen Verfahrens mit den eingangs definierten Merkmalskomplexen eingesetzt werden, da das Kryogen im Halsrohr zur Kühlung unter Vakuum abgedampft werden kann.

Nachteilig bei sämtlichen bisher in diesem Zusammenhang bekannten einschlägigen Verfahren zur Kühlung eines im MR-Messbetrieb trockenen, also nicht von kryogenem Medium umgebenen, supraleitfähigen MR-Magnetspulensystems ist der Umstand, dass zum Vorkühlen des Magnetsystems -in der Regel ausgehend von Raumtemperatur- auf eine kryogene Temperatur, bei der ein Laden der supraleitfähigen Magnetspulen mit Strom erfolgen kann, stets und unabdingbar technisches Fachpersonal erforderlich ist.

Ein autarker Betrieb der MR-Apparatur in dieser Betriebsphase, die grundsätzlich immer nach der ersten Installation des Systems beim Nutzer, aber auch jedes Mal nach einer zwischenzeitlichen Erwärmung des supraleitfähigen Magneten, etwa bei einem Quench, durchlaufen werden muss, ist ohne die Mitwirkung von kostenintensiven, speziell ausgebildeten Service-Technikern bislang jedenfalls nicht möglich.

Aufgabe der Erfindung

Demgegenüber liegt der vorliegenden Erfindung die -im Detail betrachtet zunächst relativ anspruchsvolle und komplexe- Aufgabe zugrunde, ein Verfahren der eingangs beschriebenen Art zum Betrieb einer MR-Apparatur mit einem "trocken" in einem Vakuumbehälter angeordneten, im MR-Messbetrieb Kryogen-freien, supraleitfähigen MR-Magnetspulensystem sowie mit einem Kryostaten zum Kühlen dieses Systems und auch eine Vorrichtung zur Durchführung dieses Verfahrens mit unaufwändigen, einfach beschaffbaren oder bereits in der Regel standardmäßig beim Anwender vorhandenen technischen Mitteln so zu verbessern, dass ein überwiegend autonomes und auch hinsichtlich bestimmter Prozessparameter gezielt optimierbares Herunterkühlen des MR-Magnetspulensystems auf eine kryogene Temperatur, bei der ein Laden des supraleitfähigen MR-Magnetspulensystems mit Strom erfolgen kann, auf einfachste Weise und ohne teure zusätzliche Komponenten ermöglicht wird.

Kurze Beschreibung der Erfindung

Die Erfindung ist in den unabhängigen Ansprüchen definiert. Verschiedene bevorzugte Ausführungsformen der Erfindung befinden sich in den abhängigen Ansprüchen. U

Diese Aufgabe wird durch die vorliegende Erfindung auf ebenso überraschend einfache wie wirkungsvolle Weise hinsichtlich des Betriebsverfahrens gelöst durch folgende Schritte:

(a1) Messen der aktuellen Temperatur $T_{ist}$ am MR-Magnetspulensystem und Vergleichen von $T_{ist}$ mit einem vorgebbaren ersten Temperatursollwert $T1_{soll}$, ab welchem der Vakuumbehälter ausgepumpt werden soll;

(a2) falls $T_{ist} > T1_{soll}$ Aktivieren einer außerhalb des Vakuumbehälters angeordneten Vakuumpumpe und Öffnen eines ersten Absperrventils in einer von der Vakuumpumpe in den Vakuumbehälter führenden Vakuumleitung;

(b1) Messen des aktuellen Drucks $P_{ist}$ im Vakuumbehälter und Vergleichen von $P_{ist}$ mit einem vorgebbaren ersten Drucksollwert $P1_{soll}$, bei welchem das MR-Magnetspulensystem auf kryogene Temperatur heruntergekühlt werden soll;

(b2) falls $P_{ist} < P1_{soll}$ Aktivieren des Kaltkopfes zum Kühlen des Kühlarms; (c1) Messen der aktuellen Temperatur $T_{ist}$ am MR-Magnetspulensystem und Vergleichen von $T_{ist}$ mit dem ersten Temperatursollwert $T1_{soll}$

(c2) falls $T_{ist} < T1_{soll}$ Schließen des ersten Absperrventils und Ausschalten der Vakuumpumpe;

(d1) Weiterhin Messen der aktuellen Temperatur $T_{ist}$ am MR-Magnetspulensystem und Vergleichen von $T_{ist}$ mit einem vorgebbaren zweiten Temperatursollwert $T2_{soll}$, bei welchem die Betriebstemperatur des MR-Magnetspulensystems für MR-Messungen erreicht ist und nach Erreichen der Bedingung $T_{ist} \leq T2_{soll}$ Übermittlung der Information an den Kaltkopf, dass der zweite Temperatursollwerts $T2_{soll}$ gehalten werden soll.

Im erfindungsgemäßen Verfahren ist ersichtlich das Herstellen eines ausreichend hohen Vakuums im Vakuumbehälter notwendig, bevor die Temperatur des Magnetspulensystems unter den ersten Temperatursollwert abgekühlt wird. Zum einen dient das Vakuum dazu, die Wärmekonvektion innerhalb des Behälters zu verhindern, aber zum anderen auch, um das Vereisen innerhalb des Behälters zu verhindern. Nach einem Aufwärmen kann es zum Ausgasen flüchtiger Substanzen aus dem Magnetspulensystem kommen oder wenn Luft in das Innere des Vakuumbehälters gelangt ist, wie es bei der Erstinstallation des Systems generell der Fall sein wird. Diese zumeist gasförmigen Verunreinigungen werden zunächst abgesaugt durch die Vakuumpumpe, bevor der Temperatur unter einen Wert (=erster Temperatursollwert $T1_{soll}$) gekühlt wird, bei welchem diese flüchtigen Bestandteile abkondensieren oder anfrieren. Wenn dieser Wert $T1_{soll}$ unterschritten ist in Schritt a1 oder unterschritten wird in Schritt c1, kann die Vakuumpumpe ausgeschaltet werden.

Demgemäß ist es auch wichtig, in Schritt b1 den aktuellen Unterdruck zu erfassen, bevor die aktive Kühlung beginnt.

Um die Funktionalität des MR-Systems auf Dauer zu gewährleisten, werden also im erfindungsgemäßen Verfahren nicht einfach Vakuumpumpe und Kühlung parallel angefahren, sondern zunächst die Parameter Temperatur und Druck erfasst und das Vakuum und die Kühlung Abhängigkeit der Parameter gegebenenfalls getrennt angesteuert. Es bedarf also einer kontinuierlichen Erfassung der Temperatur- und Druckwerte sowie einer sinnvollen Ansteuerung von Vakuumpumpe und Kühlung.

Damit ergibt sich ein Betriebsverfahren, welches mit Hilfe einer einfachen Kontrolleinheit -quasi auf Knopfdruck- das supraleitfähige Magnetsystem selbständig abkühlt und entsprechend auf Störungen von außen reagiert, gegebenenfalls Fehlermeldungen erzeugt und diese -beispielsweise als Emailversendet. Das Magnetspulensystem wird auf diese Weise weitestgehend autark und autonom ohne weiteres Zutun von technischem Personal betreibbar, sondern kann flexibel vom Endkunden selbst auf Betriebstemperatur gebracht werden.

Enorme Einsparungen beim Service, insbesondere hinsichtlich des Einsatzes von Fachpersonal beim Betreiber der MR-Apparatur, und geringere Ausfallzeiten der Geräte sind die Folge. Es wird insgesamt kompakter, leichter und in jeder Hinsicht kostengünstiger.

Das erfindungsgemäße Verfahren um Kryostat-basierte MR Geräte, insbesondere für die MRI, bis auf eine Temperatur herunterzukühlen, bei welcher der Magnet -gegebenenfalls wieder- geladen werden kann, ist also weitestgehend *autonom,* was vom oben diskutierten Stand der Technik nicht einmal ansatzweise nahegelegt wird. Insbesondere die Bad-basierten Systeme wären für diese Betriebsweise gänzlich ungeeignet.

Eine MR-Apparatur zur Durchführung des oben beschriebenen erfindungsgemäßen Verfahrens ist ausgestattet mit einem in einem Vakuumbehälter angeordneten, im MR-Messbetrieb trockenen, d.h. Kryogen-freien, supraleitfähigen MR-Magnetspulensystem sowie mit einem Kryostaten zum Kühlen des MR-Magnetspulensystems, welcher ein Halsrohr umfasst, das durch einen Außenmantel des Vakuumbehälters hindurch zum MR-Magnetspulensystem führt, wobei ein Kühlarm eines Kaltkopfes zumindest teilweise im Halsrohr angeordnet ist, wobei um den Kühlarm herum ein abgeschlossener Hohlraum ausgebildet ist, der gegenüber dem zu kühlenden MR-Magnetspulensystem fluiddicht abgedichtet und im Normalbetrieb der MR-Apparatur zumindest teilweise mit einem kryogenen Fluid gefüllt ist.

Hinsichtlich einer solchen MR-Apparatur wird die Erfindungsaufgabe dadurch gelöst, dass außerhalb des Vakuumbehälters eine Vakuumpumpe sowie ein erstes Absperrventil in einer von der Vakuumpumpe in den Vakuumbehälter führenden Vakuumleitung angeordnet sind, dass ein Temperatursensor zur Messung einer aktuellen Temperatur $T_{ist}$ am MR-Magnetspulensystem sowie ein erster Drucksensor zur Messung eines aktuellen Drucks $P_{ist}$ im Vakuumbehälter vorhanden sind, und dass eine Kontrolleinheit zum Erfassen und Vergleichen der aktuellen Temperatur $T_{ist}$ am MR-Magnetspulensystem mit vorgegebenen Temperatursollwerten, zum Erfassen und Vergleichen des aktuellen Drucks $P_{ist}$ im Vakuumbehälter mit vorgegebenen Drucksollwerten sowie zur Ansteuerung eines ersten Absperrventils, der Vakuumpumpe und des Kaltkopfes konfiguriert ist, wobei die Kontrolleinheit Mittel enthält, die so angepasst sind, dass sie die Schritte des erfindungsgemäßen Verfahrens ausführen.

Ein zur Durchführung des oben beschriebenen erfindungsgemäßen Verfahrens geeigneter Kryostat trägt zur Lösung der Erfindungsaufgabe dadurch bei, dass eine Fluidleitung vorgesehen ist, die einenends in einen den Kühlarm des Kaltkopfs umgebenden Hohlraum, anderenends in ein mit einem kryogenen Fluid gefüllten Druckbehälter außerhalb des Halsrohrs mündet, und dass ein zweiter Drucksensor zur Messung des aktuellen Drucks $P_{HR}$ im Hohlraum vorhanden ist.

Schließlich erfordert eine Vorrichtung zur Durchführung des erfindungsgemäßen Verfahrens eine elektronische Kontrolleinheit, die zum Erfassen und Vergleichen einer aktuellen Temperatur $T_{ist}$ am MR-Magnetspulensystem mit vorgegebenen Temperatursollwerten, sowie zum Erfassen und Vergleichen eines aktuellen Drucks $P_{ist}$ im Vakuumbehälter mit vorgegebenen Drucksollwerten konfiguriert ist, und welche die verschiedenen Komponenten mittels eines Algorithmus unter Berücksichtigung diverser Messwerte und Parameter steuert. Die Kontrolleinheit ist wesentlich für die Funktionalität des autarken Kühlens, denn es bedarf einer kontinuierlichen Erfassung der Temperatur- und Druckwerte und einer sinnvollen Ansteuerung von Vakuumpumpe und Kühlung in Abhängigkeit der vorliegenden Messwerte mittels des dafür eingerichteten Algorithmus. Die Kontrolleinheit ist ausgestaltet zur Verwendung in einer MR-Apparatur mit einem in einem Vakuumbehälter angeordneten supraleitfähigen MR-Magnetspulensystem, mit einem Kryostaten zum Kühlen des MR-Magnetspulensystems, welcher ein Halsrohr umfasst, das durch einen Außenmantel des Vakuumbehälters hindurch zum MR-Magnetspulensystem führt, wobei ein Kühlarm eines Kaltkopfes zumindest teilweise im Halsrohr angeordnet ist, sowie mit einer außerhalb des Vakuumbehälters angeordneten Vakuumpumpe und einem ersten Absperrventil in einer von der Vakuumpumpe in den Vakuumbehälter führenden Vakuumleitung.

Die Kontrolleinheit trägt zur Lösung der Erfindungsaufgabe dadurch bei, dass sie eine Messeinheit aufweist, an welche ein Temperatursensor zur Messung der aktuellen Temperatur $T_{ist}$ am MR-Magnetspulensystem sowie ein Drucksensor zur Messung des aktuellen Drucks $P_{ist}$ im Vakuumbehälter angeschlossen sind Außerdem umfasst die Kontrolleinheit eine Ansteuereinheit zum Öffnen und Schließen des ersten Absperrventils, zur Aktivierung und Deaktivierung der Vakuumpumpe sowie zur Aktivierung und Deaktivierung des Kaltkopfes und enthält eine Prozessoreinheit, die als Schnittstelle zwischen der Messeinheit und der Ansteuereinheit angeordnet ist zum Abgleich der erfassten Sensorparameter mit den Sollparametern und der Verarbeitung der Daten zur Ansteuerung von Kaltkopf, Vakuumpumpe und Absperrventil.

Besondere Vorteile des erfindungsgemäßen, autonomen Kühlverfahrens:

1. Automatisierte Abkühlprozedur bei erstmaliger Inbetriebnahme einer MR-Apparatur mit supraleitfähigem Magnetspulensystem
2. Automatisierte Abkühlprozedur nach Überhitzung des Magnetspulensystems nach einem Ausfall der Kühleinheit oder durch einen Quench (="Auto Cooling")
3. Permanente Temperatur- und Druck-Messungen ermöglichen

    a) automatisierte Überprüfung der aktuellen Temperatur $T_{ist}$ am MR-Magnetspulensystem;
    b) automatisierte Überprüfung des aktuellen Drucks $P_{ist}$ im Vakuumbehälter.

Varianten, bevorzugte Ausführungsformen und Weiterbildungen der Erfindung

Vorteilhaft können auch Varianten des erfindungsgemäßen Verfahrens sein, bei denen in einem weiteren Schritt der Druck $P_{HR}$ des kryogenen Fluids im Halsrohr über ein Manometer an der Zufuhr für kryogenes Fluid, insbesondere Helium, überwacht und zwischen 900 mbar und 1100 mbar gehalten wird.

Bevorzugte Ausführungsform des erfindungsgemäßen Verfahrens zeichnen sich dadurch aus, dass das Halsrohr über ein erstes Ventil V1 mit einer Heliumzufuhr verbunden ist, wobei zeitlich nach Schritt (d1) in einem Schritt (e) Helium in das Halsrohr zugeführt und verflüssigt wird. Dadurch wird das Heliumreservoir im Halsrohr autonom wieder nachgefüllt bei laufendem Kaltkopf, an welchem das Helium bei einem entsprechenden Druck abkondensieren kann. Das Heliumreservoir stellt einen Kältepuffer dar, beispielsweise beim Ausfall der Kühlung. Die auf diese Weise entstehende Heat-Pipe leitet die Wärme besonders effektiv von der Spule zum Kaltkopf und entkoppelt gleichzeitig die mechanischen Vibrationen des Kühlers.

Besonders bevorzugt ist auch eine Klasse von Ausführungsformen der Erfindung, bei denen die Zufuhrleitung zum Halsrohr über ein weiteres Ventil V2 mit der Vakuumpumpe verbunden ist und zeitlich nach Schritt (a2) und vor Schritt (b1) das Halsrohr leergepumpt wird mit den Schritten

(a3) Messen der aktuellen Temperatur $T_{ist}$ am MR-Magnetspulensystem und Vergleichen von $T_{ist}$ mit einem vorgebbaren dritten Temperatursollwert $T3_{soll}$, ab welchem das Halsrohr ausgepumpt werden soll; und
(a4) falls $T_{ist} > T3_{soll}$ Aktivieren einer Vakuumpumpe und Öffnen des zweiten Absperrventils V2 in einer von der Vakuumpumpe zum Halsrohr führenden Vakuumleitung.

$T3_{soll}$ stellt sich bei längerer Erwärmung des MR-Magnetspulensystems ein. In diesem Fall ist es notwendig, das Halsrohr zunächst von Fremdgasen durch Evakuieren zu befreien, damit diese beim Herunterkühlen auf kryogene Temperaturen nicht anfrieren und somit die Funktionalität des Kryostaten negativ beeinflussen. Eine derartige Vereisung beispielsweise an Sicherheitsventilen stellt auch eine Gefahr dar, weil diese sich gegebenenfalls bei Überdruck nicht mehr öffnen lassen.

Es ist vorteilhaft, wenn die Schritte a3 und a4 durchgeführt werden, bevor der Kaltkopf aktiviert wird. Nach dem Schritt des Auspumpens a4 wird das Helium vorzugsweise über eine Heliumzufuhr wieder mit frischem Helium befüllt. Das geschieht durch Ausschalten der Pumpe und (nach kurzer Wartezeit) Öffnen des Ventils V1, damit das gasförmige Helium in das evakuierte Halsrohr strömen kann. Es wird mit dem zweiten Drucksensor überprüft bis die Zufuhrleitungen und das Halsrohr mit Helium gefüllt haben und sich dann ein stabiler Druckwert einstellt. Außerdem kann während des Ladens am Halsrohr gepumpt werden und somit für eine gewisse Zeit eine tiefere Temperatur im Halsrohr erzeugt werden.

Vorteilhaft sind Weiterbildungen dieser Verfahrensvarianten, die sich dadurch auskennzeichnen, dass bei Ausfall des Kaltkopfes in einem Schritt (d2) mit der Vakuumpumpe das flüssige Helium im Halsrohr abgepumpt wird, um das MR-Magnetspulensystems zu kühlen. Das flüssige Helium stellt einen Kältepuffer dar, der genutzt werden kann, um eine Notfallkühlung bereitzustellen. Beim Abpumpen von flüssigem Helium stellt sich ein niedrigerer Druck ein, was dazu führt, dass das Helium in den gasförmigen Zustand übergeht und die Verdampfungswärme dem Kryostaten zusätzliche Wärme entzieht und somit für zusätzliche Kühlung sorgt.

Bevorzugte Ausführungsformen des erfindungsgemäßen Verfahrens sind dadurch gekennzeichnet, dass die vorgebbaren Temperatursollwerte $T1_{soll}$, $T2_{soll}$ und $T3_{soll}$ sowie der vorgebbare Drucksollwert $P1_{soll}$ aus folgenden Wertebereichen ausgewählt werden:

$$5K \leq T1_{soll} \leq 20K,$$

vorzugsweise etwa 8K;

$$3K \leq T2_{soll} \leq 5K,$$

vorzugsweise etwa 4,2K;

$$250K \leq T3_{soll} \leq 300K,$$

vorzugsweise etwa 280K

$$10^{-4}\text{mbar} \leq P1_{soll} \leq 10^{-1}\text{mbar},$$

vorzugsweise etwa $10^{-3}$mbar

Diese Werte werden verwendet, wenn das MR-Spulensystem LTS-Leiter (Niedertemperatursupraleiter) enthält, die typischerweise bei der Temperatur von flüssigem Helium, also kleiner als 4,2K betrieben werden. Das kryogene Fluid im Halsrohr ist demgemäß Helium.

$T1_{soll}$ entspricht der Temperatur, ab welcher das Vakuum im Vakuumbehälter wiederhergestellt werden muss.

$T2_{soll}$ entspricht der Betriebstemperatur des MR-Magnetspulensystems bei Verwendung von LTS-Leitern.

$T3_{soll}$ entspricht der Temperatur eines vollständig aufgewärmten Magnetspulensystems.

$P1_{soll}$ ist das minimale Vakuum in der Vakuumkammer, ab welchem man davon ausgehen kann, dass nur noch wenig Restgase vorhanden sind und daher mit der Kühlung begonnen werden kann.

In den Rahmen der vorliegenden Erfindung fällt auch die bereits oben beschriebene Magnetresonanz(="MR")-Apparatur zur Durchführung des erfindungsgemäßen Verfahrens. Diese kann bei vorteilhaften Ausführungsformen so ausgestaltet werden, dass die Vakuumpumpe mindestens 2stufig aufgebaut ist und eine Turbomolekularpumpe sowie eine Vorpumpe hierfür, vorzugsweise eine Membranpumpe, aufweist. Beide Pumpen sind vorzugsweise in Serie geschaltet. In der Regel erreichen nur diese zweistufigen Pumpen ein ausreichendes Hochvakuum.

Des Weiteren kann der -ebenfalls bereits oben beschriebene, für die erfindungsgemäße MR-Apparatur erforderliche- Kryostat zum Kühlen des MR-Magnetspulensystems dadurch weitergebildet werden, dass das mit dem Hohlraum verbundene Ende der Fluidleitung über ein zweites Absperrventil in einen Bereich der Vakuumleitung zwischen dem ersten Absperrventil und der Turbomolekularpumpe mündet, und dass das mit dem Druckbehälter verbundene Ende der Fluidleitung über ein drittes Absperrventil in einen Bereich der Vakuumleitung zwischen der Turbomolekularpumpe und ihrer Vorpumpe mündet. Die getrennten Ventile führen dazu, dass die Heliumzufuhr getrennt von den Vakuumpumpen angeordnet ist, damit die Heliumzufuhr beim Pumpen am Halsrohr nicht leergepumpt wird.

In den Rahmen der vorliegenden Erfindung fällt auch eine Kontrolleinheit zur Durchführung des erfindungsgemäßen Verfahrens, wie sie ebenfalls bereits oben beschrieben ist.

Besonders bevorzugt ist eine Klasse von Ausführungsformen der erfindungsgemäßen Kontrolleinheit, die dadurch gekennzeichnet sind, dass um den Kühlarm herum ein abgeschlossener Hohlraum ausgebildet ist, der gegenüber dem zu kühlenden MR-Magnetspulensystem fluiddicht abgedichtet und im Normalbetrieb der MR-Apparatur zumindest teilweise mit einem kryogenen Fluid gefüllt ist, dass an die Messeinheit der zweite Drucksensor zur Messung des aktuellen Drucks $P_{HR}$ in dem den Kühlarm des Kaltkopfs umgebenden Hohlraum angeschlossen ist, und dass die Ansteuereinheit zum Öffnen und Schließen des zweiten und des dritten Absperrventils konfiguriert ist.

Wenn das Magnetspulensystem noch warm ist, dient die Messung von $P_{HR}$ zur Überwachung des Drucks beim initialen Spülen des Halsrohrs mit He. Dabei wird abwechselnd mit der Vakuumpumpe, bei Verwendung einer zweistufigen Pumpe vorzugsweise mit der Membranpumpe, das Halsrohr über V2 geleert und über V1 mit Helium befüllt, sodass möglichst wenig Fremdgase im Halsrohr vorhanden sind vor der Kühlung.

Die Messung von $P_{HR}$ dient auch dazu, nach vollzogenem Herunterkühlen zu überwachen, ob ausreichend Helium im Druckbehälter vorhanden ist, um das Befüllen des Halsrohrs mit Helium zu überwachen. Es dient auch dazu, die Manometer-Einstellung am Helium-Druckbehälter zu überprüfen während des Betriebs, damit kein Über- oder Unterdruck an der Zufuhrleitung entsteht.

In der Praxis bewähren sich Weiterbildungen dieser Ausführungsformen, bei welchen eine Verbindung vom Halsrohr zur Vakuumpumpe vorhanden ist, wobei die Kontrolleinheit die Steuerung von V2 zur Vakuumpumpe regelt. Die Vakuumpumpe dient zum einen dazu, bei zu starker Erwärmung des Kryostaten, das Halsrohr zunächst vollständig von Fremdgasen zu befreien, bevor die Kühlung beginnt. Das verhindert das An-eisen von Fremdstoffen, welches die Funktionalität des Kaltkopfs beeinträchtigen würde. Zum anderen kann die Vakuumpumpe sinnvoll dann im kalten Zustand eingesetzt werden, um bei Ausfall des Kaltkopfes die Erwärmung des Kryostaten durch Abpumpen des vorhandenen Heliums zu verzögern. Die Kontrolleinheit regelt die Ansteuerung von V2 und Vakuumpumpe in Abhängigkeit von den gemessenen Parametern.

Alternativ oder ergänzend zeichnen sich andere Weiterbildungen dadurch aus, dass eine Verbindung von einer Heliumgaszufuhr zum Halsrohr vorhanden ist, und dass die Kontrolleinheit die Steuerung der He-Zufuhr über das erste Ventil V1 regelt. Auf diese Weise kann nach Strom oder Wasserausfällen kontrolliert Helium verflüssigt werden, um das kleine Reservoir im Halsrohr wieder aufzufüllen. Dadurch wird gewährleistet, dass immer genügend flüssiges Helium in Halsrohr ist, um bei einem Kühlerausfall einige Stunden ohne Quench zu überstehen.

Ganz besonders bevorzugt sind Anwendungen der erfindungsgemäßen Verfahrensvarianten und Vorrichtungen im Bereich der Magnetresonanz, insbesondere in der NMR-Spektroskopie und bei MRI-Apparaturen.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Detaillierte Beschreibung der Erfindung und Zeichnung

Die Erfindung ist in der Zeichnung dargestellt und wird anhand von Ausführungsbeispielen näher erläutert.

Es zeigen:

Fig. 1    eine schematische Vertikalschnitt-Darstellung einer Ausführungsform der Magnetresonanzapparatur mit nur einem Ventil zur Durchführung des erfindungsgemäßen Auto-Cooling-Verfahrens;

Fig. 2    ein Flussdiagramm des prinzipiellen Verfahrensablaufes des erfindungsgemäßen Auto-Cooling-Verfahrens bei Ausführungsformen mit nur einem Ventil wie in Fig. 1;

Fig. 3    ein schematisiertes Flussdiagramm mit den Verfahrensschritten gemäß der Ansprüche bei Ausführungsformen mit nur einem Ventil wie in Fig. 1;

Fig. 4    ein Flussdiagramm des prinzipiellen Ablaufs des erfindungsgemäßen Auto-Cooling-Verfahrens in Form eines Algorithmus, wie er in einem entsprechenden Programm in der Kontrolleinheit ablaufen soll, und zwar für Ausführungsformen mit nur einem Ventil wie in Fig. 1;

Fig. 5    eine schematische Vertikalschnitt-Darstellung einer Ausführungsform der Magnetresonanzapparatur mit drei Ventilen zur Durchführung des erfindungsgemäßen Auto-Cooling-Verfahrens;

Fig. 6    ein Flussdiagramm des prinzipiellen Verfahrensablaufes des erfindungsgemäßen Auto-Cooling-Verfahrens bei Ausführungsformen mit drei Ventilen wie in Fig. 5;

Fig. 7    ein schematisiertes Flussdiagramm mit den Verfahrensschritten gemäß der Ansprüche bei Ausführungsformen mit drei Ventilen wie in Fig. 5; und

Fig. 8    ein Flussdiagramm des prinzipiellen Ablaufs des erfindungsgemäßen Auto-Cooling-Verfahrens in Form eines Algorithmus, wie er in einem entsprechenden Programm in der Kontrolleinheit ablaufen soll, und zwar für Ausführungsformen mit drei Ventilen wie in Fig. 5.

Die vorliegende Erfindung befasst sich in ihrem Kern mit einem speziell modifizierten Verfahren zum Betrieb einer **Magnetresonanz-Apparatur 10** (="MR-Apparatur"), insbesondere mit dem autonomen Herunterkühlen einer supraleitfähigen Magnetanordnung.

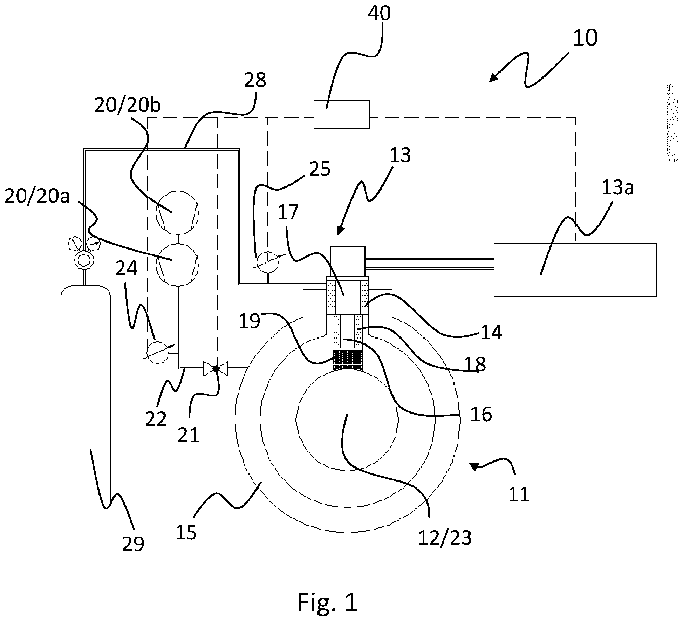

**Fig. 1** zeigt schematisch eine besonders einfache Ausführungsform der Magnetresonanz-Apparatur 10 mit nur *einem Ventil* zur Durchführung des erfindungsgemäßen Auto-Cooling-Verfahrens.

Die MR-Apparatur 10 umfasst einen **Vakuumbehälter 11** mit einem supraleitfähigen **MR-Magnetspulensystem 12**. Im MR-Messbetrieb ist dieses MR-Magnetspulensystem 12 trocken, das heißt Kryogen-frei. Die Kühlung erfolgt über einen **Kryostaten 13,** der mit einen **Kompressor 13a** verbunden ist. Der Kryostat 13 beinhaltet ein **Halsrohr 14,** welches durch einen **Außenmantel 15** des Vakuumbehälters 11 hindurch zum MR-Magnetspulensystem 12 geführt wird. Im Halsrohr 14 des Kryostaten 13 ist ein **Kühlarm 16** eines **Kaltkopfes 17** angeordnet. Ein **Hohlraum 18** ist um den Kühlarm 16 herum ausgebildet. Der Hohlraum 18 ist gegenüber dem zu kühlenden MR-Magnetspulensystem 12 fluiddicht abgedichtet. Im hier gezeigten Betriebszustand ist der Hohlraum 18 teilweise mit einem **kryogenen Fluid 19** (z. B. flüssiges Helium), sowie gasförmigem Helium gefüllt.

Außerhalb des Vakuumbehälter 11 ist eine **Vakuumpumpe 20** angeordnet, die hier als 2stufige Vakuumpumpe 20 ausgebildet ist. Vakuumpumpe 20 umfasst dabei eine **Turbomolekularpumpe 20a** mit einer **Vorpumpe 20b** (z. B. einer Membranpumpe). Die Vakuumpumpe 20 ist mit einem ersten **Absperrventil 21** (Absperrventil V3) über eine **Vakuumleitung 22** mit dem Vakuumbehälter 11 verbunden.

Am MR-Magnetspulensystem 12 ist ein **Temperatursensor 23** zur Messung einer aktuellen Temperatur $T_{ist}$ am MR-Magnetspulensystem 12 vorhanden. Ein **erster Drucksensor 24,** der über die Vakuumleitung 22 mit dem Vakuumbehälter 11 verbunden ist, misst einen aktuellen Druck $P_{ist}$ im Vakuumbehälter 11. Eine **Kontrolleinheit 40** erfasst und vergleicht die aktuelle Temperatur $T_{ist}$ am MR-Magnetspulensystem 12 mit vorgegeben Temperatursollwerten. Weiterhin erfasst und vergleicht die Kontrolleinheit 40 den aktuellen Druck $P_{ist}$ im Vakuumbehälter 11 mit vorgegebenen Drucksollwerten. Die Kontrolleinheit 40 ist weiterhin so konfiguriert, dass sie das erste Absperrventil 21, die Vakuumpumpe 20 und den Kompressor 13a des Kaltkopfes 17 ansteuern kann.

Die Kontrolleinheit 40 beinhaltet eine Messeinheit, eine Ansteuereinheit und eine Prozessoreinheit. An die Messeinheit ist der Temperatursensor 23 angeschlossen, mit dem die aktuelle Temperatur $T_{ist}$ am MR-Magnetspulensystem 12 gemessen wird. Weiterhin ist an die Messeinheit der Drucksensor 24 angeschlossen, mit dem der aktuelle Druck $P_{ist}$ im Vakuumbehälter 11 gemessen wird. Die Ansteuereinheit ist mit dem ersten Absperrventil 21 verbunden, welches die Ansteuereinheit öffnen und schließen kann. Weiterhin ist die Ansteuereinheit mit der Vakuumpumpe 20 und dem Kaltkopf 17 (beziehungsweise dem Kompressor 13a) verbunden, welche die Ansteuereinheit aktivieren und deaktivieren kann. Die Prozessoreinheit ist zwischen der Messeinheit und der Ansteuereinheit angeordnet. Die Prozessoreinheit gleicht die erfassten Parameter des Temperatursensors 23 und des Drucksensors 24 mit den Sollparametern ab. Diese Daten werden von der Prozessoreinheit verarbeitet und zur Ansteuerung des Kaltkopfs 17, der Vakuumpumpe 20 und des Absperrventils 21 genutzt.

Über einen **zweiten Drucksensor 25,** welcher an einer **Verbindung 28** angeschlossen ist, die von einer **Heliumzufuhr 29** in den Hohlraum 18 des Kryostaten 13 führt, kann der aktuelle Druck $P_{HR}$ in Hohlraum 18 gemessen werden. Der zweite Drucksensor 25 ist ebenfalls mit der Messeinheit der Prozessoreinheit verbunden.

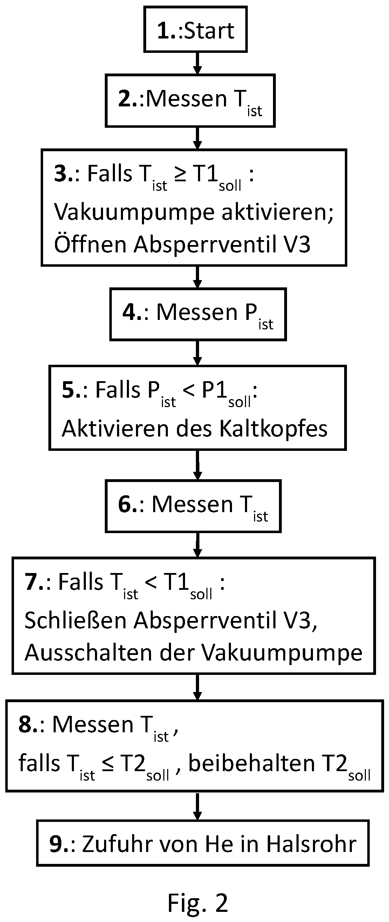

Der prinzipielle Ablauf des erfindungsgemäßen Abkühlverfahrens für Ausführungsformen mit nur einem Ventil ist in **Fig. 2** als Flussdiagramm dargestellt.

Ausführungsbeispiel:

Der Ablauf des autonomen Abkühlverfahrens kann bei Ausführungsvarianten folgende Schritte umfassen:

1. Der Betrieb der MR-Apparatur wird gestartet. In diesem Betriebszustand ist das Absperrventil V3 geschlossen und die Vakuumpumpe deaktiviert.
Die Heliumzufuhr ist direkt mit dem Halsrohr verbunden. Das gasförmige Helium wird verflüssigt und das flüssige Helium kühlt die MR-Magnetanordnung. Die Verflüssigung läuft solange ab, bis das System im thermodynamischen Gleichgewicht ist.

2. Der Temperatursensor misst die aktuelle Temperatur $T_{ist}$ am MR-Magnetspulensystem.

3. Die Temperatur $T_{ist}$ wird an die Kontrolleinheit übermittelt und dort in der Prozessoreinheit mit einem vorgegebenen Temperatursollwert $T1_{soll}$, der hier 8K beträgt, verglichen. Wenn $T_{ist} \geq T1_{soll}$ wird die Kontrolleinheit aktiv. Die Kontrolleinheit öffnet das Absperrventil V3 und aktiviert die Vakuumpumpe.
Eine Temperaturerhöhung tritt auf, wenn beispielsweise der Kompressor ausfällt und damit die Kühlung des MR-Magnetspulensystems. Der Wärmeeintrag aus der Umgebung auf das MR-Magnetspulensystem erhöht sich. Es kommt allerdings nicht sofort zu einer Erwärmung des MR-Magnetspulensystems. Zuerst verdampft das flüssige Helium und kühlt somit das MR-Magnetspulensystem. Das verdampfte Helium wird über ein Druckablassventil abgeführt. Bei einem längeren Ausfall des Kompressors kann allerdings der Fall eintreten, dass das Helium komplett verdampft ist und dass MR-Magnetspulensystem quencht und sich erwärmt. Durch das Aufwärmen werden aus dem MR-Magnetspulensystem Gase im Vakuumbehälter freigesetzt. Diese Gase verschlechtern das Vakuum, was sich wiederum negativ auf die Wärmeisolation auswirkt. Ein zu schnelles und unkontrolliertes Aufwärmen droht. Um dies zu verhindern, wird frühzeitig die Kontrolleinheit aktiv, um das Absperrventil V3 zu öffnen und die Vakuumpumpe zu aktivieren, damit das Vakuum im Vakuumbehälter möglichst lange erhalten und damit der Wärmeeintrag auf das MR-Magnetspulensystem soweit verringert werden kann, dass ein unkontrolliertes Erwärmen des MR-Magnetspulensystems unterbunden wird.

4. Der Drucksensor misst den aktuellen Druck $P_{ist}$ des Vakuumbehälters.

5. Der Druck $P_{ist}$ wird an die Kontrolleinheit übermittelt und dort in der Prozessoreinheit mit einem vorgegebenen Drucksollwert $P1_{soll}$, der hier $10^{-3}$ mbar beträgt, verglichen. Wenn $P_{ist} < P1_{soll}$ wird die Kontrolleinheit aktiv. Die Kontrolleinheit aktiviert den Kaltkopf zum Kühlen des Kühlarms.
Über den Drucksollwert $P1_{soll}$ wird sichergestellt, dass ein ausreichend großes Vakuum im Vakuumbehälter herrscht und somit der Wärmeeintrag auf das MR-Magnetspulensystem verringert wird. Ist dieser Wert erreicht, wird der Kaltkopf wieder heruntergekühlt, um die MR-Apparatur wieder in den Normalbetrieb zu überführen.

6. Der Temperatursensor misst die aktuelle Temperatur $T_{ist}$ am MR-Magnetspulensystem.

7. Die Temperatur $T_{ist}$ wird an die Kontrolleinheit übermittelt und dort in der Prozessoreinheit mit dem vorgegebenen Temperatursollwert $T1_{soll}$, verglichen. Wenn $T_{ist} < T1_{soll}$ wird die Kontrolleinheit aktiv. Die Kontrolleinheit schließt das Absperrventil V3 und deaktiviert die Vakuumpumpe.

8. Der Temperatursensor misst weiterhin die aktuelle Temperatur $T_{ist}$ am MR-Magnetspulensystem. Die Temperatur $T_{ist}$ wird an die Kontrolleinheit übermittelt und dort in der Prozessoreinheit mit einem vorgegebenen Temperatursollwert $T2_{soll}$, der hier 4,2 K beträgt, verglichen. Wenn $T_{ist} \leq T2_{soll}$ wird die

Kontrolleinheit aktiv. Die Kontrolleinheit übermittelt an den Kaltkopf, die Temperatur zu halten.

9. Gasförmiges Helium wird dem Halsrohr wieder zugeführt.

Die Temperatur $T_{ist}$ reicht aus, um das gasförmige Helium zu verflüssigen. Das flüssige Helium kühlt das MR-Magnetspulensystem und die Verflüssigung läuft solange ab, bis das System im thermodynamischen Gleichgewicht ist.

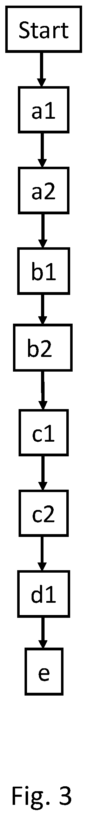

In **Fig. 3** ist ein schematisiertes Flussdiagramm mit den Verfahrensschritten gemäß der Ansprüche für Ausführungsformen mit nur einem Ventil dargestellt.

Start: Die MR-Apparatur wird in Betrieb genommen.

a1: Die aktuelle Temperatur $T_{ist}$ am MR-Magnetspulensystem wird gemessen und mit dem vorgebbaren ersten Temperatursollwert $T1_{soll}$ verglichen, ab dem der Vakuumbehälter ausgepumpt werden soll.

a2: Wenn $T_{ist} > T1_{soll}$ wird die außerhalb des Vakuumbehälters angeordnete Vakuumpumpe aktiviert und das erste Absperrventil in der von der Vakuumpumpe in den Vakuumbehälter führenden Leitung geöffnet.

b1: Der aktuelle Druck $P_{ist}$ im Vakuumbehälter wird gemessen und mit einem vorgebbaren ersten Drucksollwert $P1_{soll}$ verglichen, bei dem das MR-Magnetspulensystem auf kryogene Temperatur heruntergekühlt werden soll.

b2: Wenn $P_{ist} < P1_{soll}$ wird der Kaltkopf zum Kühlen des Kühlarms aktiviert.

c1: Die aktuelle Temperatur $T_{ist}$ am MR-Magnetspulensystem wird gemessen und mit dem ersten Temperatursollwert $T1_{soll}$ verglichen.

c2: Wenn $T_{ist} < T1s_{oll}$ wird das erste Absperrventil geschlossen und die Vakuumpumpe ausgeschalten.

d1: Die aktuelle Temperatur $T_{ist}$ am MR-Magnetspulensystem wird gemessen und mit dem zweiten Temperatursollwert $T2_{soll}$ verglichen, bei dem die Betriebstemperatur des MR-Magnetspulensystems für MR-Messungen erreicht ist. Der zweite Temperatursollwert $T2_{soll}$ wird beibehalten.

e: Helium wird in das Halsrohr zugeführt und verflüssigt.

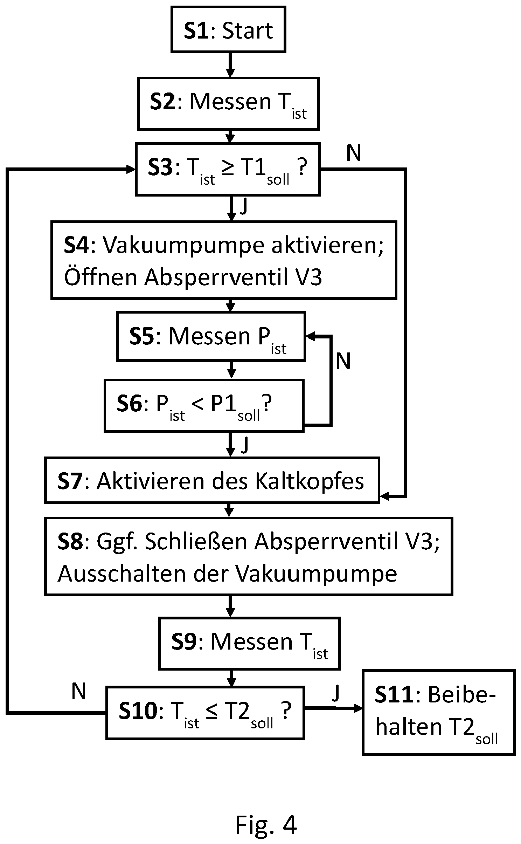

Der prinzipielle Ablauf des erfindungsgemäßen Abkühlverfahrens in Form eines Algorithmus, wie er in einem entsprechenden Programm in der Kontrolleinheit ablaufen soll, für Ausführungsformen mit nur einem Ventil ist in **Fig. 4** als Flussdiagramm dargestellt.

Der Algorithmus lässt sich in folgende Schritte unterteilen:

S1: Die Kontrolleinheit wird gestartet.

S2: Der Temperatursensor des MR-Magnetspulensystems, der mit der Messeinheit verbunden ist, misst die aktuelle Temperatur $T_{ist}$.

S3: Die Temperatur $T_{ist}$ wird in der Prozessoreinheit mit dem Wert $T1_{soll}$ verglichen und es wird geprüft, ob Tist $\geq T1_{soll}$. Wenn die Prüfung negativ ausfällt, wird der Algorithmus bei S7 fortgesetzt. Wenn die Prüfung positiv ausfällt, aktiviert die Ansteuereinheit die Vakuumpumpe und öffnet das Absperrventil V3.

S4: Die Ansteuereinheit aktiviert die Vakuumpumpe und öffnet das Absperrventil V3.

S5: Der Drucksensor für den Vakuumbehälter, der mit der Messeinheit verbunden ist, misst den aktuellen Druck $P_{ist}$.

S6: Der Druck $P_{ist}$ wird in der Prozessoreinheit mit dem Wert $P1_{soll}$ verglichen und es wird geprüft, ob $P_{ist} < P1_{soll}$. Wenn die Prüfung negativ ausfällt, wird erneut der Druck $P_{ist}$ gemessen (und der Algorithmus wird bei S5 fortgesetzt). Wenn die Prüfung positiv ausfällt, aktiviert die Ansteuereinheit den Kaltkopf.

S7: Die Ansteuereinheit aktiviert den Kaltkopf.

S8: Die Ansteuereinheit schließt gegebenenfalls das Absperrventil V3 und deaktiviert die Vakuumpumpe.

S9: Der Temperatursensor des MR-Magnetspulensystems, der mit der Messeinheit verbunden ist, misst die aktuelle Temperatur $T_{ist}$.

S10: Die Temperatur $T_{ist}$ wird in der Prozessoreinheit mit dem Wert $T2_{soll}$ verglichen und es wird geprüft, ob $T_{ist} \geq T2_{soll}$. Wenn die Prüfung negativ ausfällt, wird der Algorithmus bei S3 fortgesetzt. Wenn die Prüfung positiv ausfällt, signalisiert die Ansteuereinheit, dass der Kaltkopf die Temperatur $T2_{soll}$ beibehalten soll.

S11: Die Ansteuereinheit signalisiert dem Kaltkopf, dass er die Temperatur $T2_{soll}$ beibehalten soll.

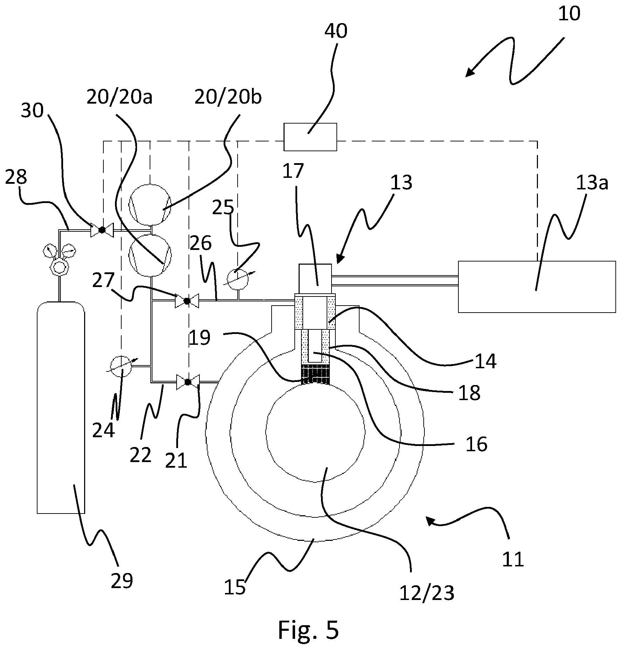

**Fig. 5** zeigt schematisch eine besonders einfache Ausführungsform einer Magnetresonanzapparatur 10 (MR-Apparatur) mit *drei Ventilen* zur Durchführung des erfindungsgemäßen Auto-Cooling-Verfahrens.

Die MR-Apparatur 10 umfasst den Vakuumbehälter 11 mit dem supraleitfähigen MR-Magnetspulensystem 12. Im MR-Messbetrieb ist dieses MR-

Magnetspulensystem 12 trocken, das heißt Kryogen-frei. Die Kühlung erfolgt über einenden Kryostaten 13, der mit dem Kompressor 13a verbunden ist. Der Kryostat 13 beinhaltet das Halsrohr 14, welches durch den Außenmantel 15 des Vakuumbehälters 11 hindurch zum MR-Magnetspulensystem 12 geführt wird. Im Halsrohr 14 des Kryostaten 13 ist der Kühlarm 16 des Kaltkopfs 17 angeordnet. Der Hohlraum 18 ist um den Kühlarm 16 herum ausgebildet. Der Hohlraum 18 ist gegenüber dem zu kühlenden MR-Magnetspulensystem 12 fluiddicht abgedichtet. Im hier gezeigten Betriebszustand ist der Hohlraum 18 teilweise mit kryogenem Fluid 19 (z. B. flüssiges Helium), sowie gasförmigem Helium gefüllt.

Außerhalb des Vakuumbehälter 11 ist die Vakuumpumpe 20 angeordnet, die hier als 2stufige Vakuumpumpe 20 ausgebildet ist. Vakuumpumpe 20 umfasst dabei die Turbomolekularpumpe 20a mit der Vorpumpe 20b (z. B. einer Membranpumpe). Die Vakuumpumpe 20 ist mit dem ersten Absperrventil 21 (Absperrventil V3) über die Vakuumleitung 22 mit dem Vakuumbehälter 11 verbunden. Weiterhin ist die Vakuumpumpe 20 mit einem zweiten **Absperrventil 27** (Absperrventil V2) über eine **Verbindung 26** mit dem Halsrohr 14 verbunden.

Am MR-Magnetspulensystem 12 ist der Temperatursensor 23 zur Messung einer aktuellen Temperatur $T_{ist}$ am MR-Magnetspulensystem 12 vorhanden. Der erste Drucksensor 24, der über die Vakuumleitung 22 mit dem Vakuumbehälter 11 verbunden ist, misst einen aktuellen Druck $P_{ist}$ im Vakuumbehälter 11. Der zweite Drucksensor 25, der über die Verbindung 26 mit dem Halsrohr 14 verbunden ist, misst einen aktuellen Druck $P_{HR}$ im Halsrohr. Die Kontrolleinheit 40 (hier nicht gezeigt) erfasst und vergleicht die aktuelle Temperatur $T_{ist}$ am MR-Magnetspulensystem 12 mit vorgegeben Temperatursollwerten. Weiterhin erfasst und vergleicht die Kontrolleinheit 40 den aktuellen Druck $P_{ist}$ im Vakuumbehälter 11 mit vorgegebene Drucksollwerten. Die Kontrolleinheit 40 ist weiterhin so konfiguriert, dass sie das erste Absperrventil 21, die Vakuumpumpe 20 und den Kompressor 13a des Kaltkopfes 17 ansteuern kann. Die Kontrolleinheit 40 beinhaltet die Messeinheit, die Ansteuereinheit und die Prozessoreinheit. An die Messeinheit ist der Temperatursensor 23 angeschlossen, mit dem die aktuelle Temperatur $T_{ist}$ am MR-Magnetspulensystem 12 gemessen wird. Weiterhin ist an die Messeinheit der erste Drucksensor 24 angeschlossen, mit dem der aktuelle Druck $P_{ist}$ im Vakuumbehälter 11 gemessen wird. Ebenso ist der zweite Drucksensor 25 an die Messeinheit angeschossen, mit der der aktuelle Druck $P_{HR}$ im Halsrohr 14 gemessen wird. Die Ansteuereinheit ist mit dem ersten Absperrventil 21, dem zweiten Absperrventil 27 und einem dritten **Absperrventil 30** (Absperrventil V1) verbunden, welche die Ansteuereinheit öffnen und schließen kann. Absperrventil 30 ist in Verbindung 28 integriert, die die Heliumzufuhr 29 und das Halsrohr 14 verbindet. Weiterhin ist die Ansteuereinheit mit der Vakuumpumpe 20 und über den Kompressor 13a mit dem Kaltkopf 17 verbunden, welche die Ansteuereinheit aktivieren und deaktivieren kann. Die Prozessoreinheit ist zwischen der Messeinheit und der Ansteuereinheit angeordnet. Die Prozessoreinheit gleicht die erfassten Parameter des Temperatursensors 23, des Drucksensors 24 und des Drucksensors 25 mit den Sollparametern ab. Diese Daten werden von der Prozessoreinheit verarbeitet und zur Ansteuerung des Kaltkopfs 17, der Vakuumpumpe 20 und der Absperrventile 21, 27, 30 genutzt.

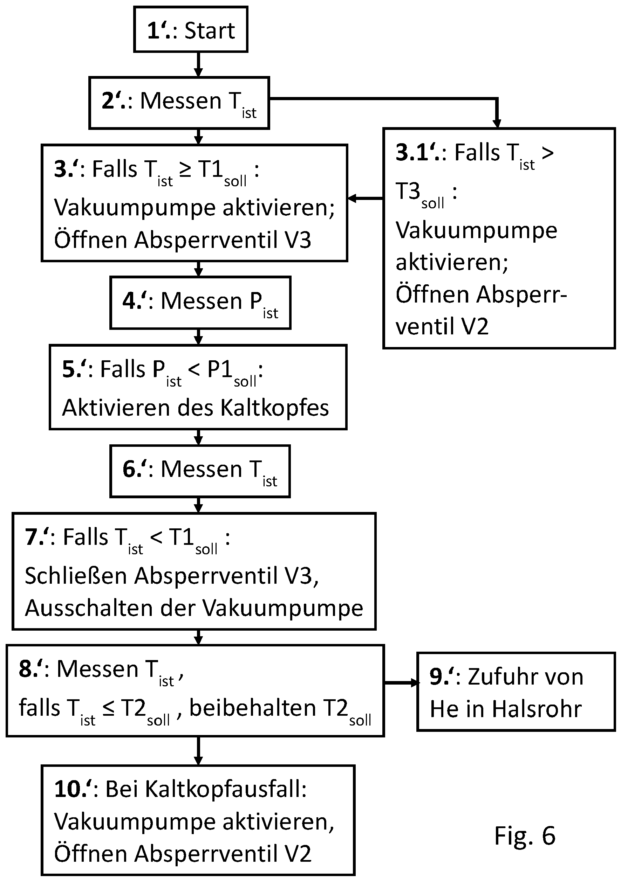

Der prinzipielle Ablauf des erfindungsgemäßen Abkühlverfahrens für Ausführungsformen mit drei Ventilen ist in **Fig. 6** als Flussdiagramm dargestellt.

Ausführungsbeispiel:

Der Ablauf des autonomen Abkühlverfahrens kann bei Ausführungsvarianten folgende Schritte umfassen:

1'. Der Betrieb der MR-Apparatur wird gestartet. In diesem Betriebszustand sind die Absperrventil V1, V2 und V3 geschlossen und die Vakuumpumpe deaktiviert.

Die Heliumzufuhr ist über Absperrventil V1 mit dem Halsrohr verbunden. Das gasförmige Helium wird verflüssigt und das flüssige Helium kühlt die MR-Magnetanordnung. Die Verflüssigung läuft solange ab, bis das System im thermodynamischen Gleichgewicht ist.

2'. Der Temperatursensor misst die aktuelle Temperatur $T_{ist}$ am MR-Magnetspulensystem.

3'. Die Temperatur $T_{ist}$ wird an die Kontrolleinheit übermittelt und dort in der Prozessoreinheit mit einem vorgegebenen Temperatursollwert $T1_{soll}$, der hier 8K beträgt, verglichen. Wenn $T_{ist} \geq T1_{soll}$ wird die Kontrolleinheit aktiv. Die Kontrolleinheit öffnet das Absperrventil V3 und aktiviert die Vakuumpumpe.

3.1'. Gleichzeitig vergleicht die Prozessoreinheit die Temperatur $T_{ist}$ mit einem vorgegeben Temperatursollwert $T3_{soll}$, der hier 280 K beträgt. Wenn $T_{ist} > T3_{soll}$ wird die Kontrolleinheit aktiv. Die Kontrolleinheit öffnet das Absperrventil V2 und aktiviert die Vakuumpumpe.

Eine Temperaturerhöhung tritt auf, wenn beispielsweise der Kompressor ausfällt und damit die Kühlung des MR-Magnetspulensystems. Der Wärmeeintrag aus der Umgebung auf das MR-Magnetspulensystem erhöht sich. Es kommt allerdings nicht sofort zu einer Erwärmung des MR-Magnetspulensystems. Die Kontrolleinheit wird aktiv, wenn ein der Temperatursollwert $T3_{soll}$ überschritten wird. Das Absperrventil V2 wird geöffnet und das Heliumgas abgepumpt, wodurch das MR-Magnetspulensystem aktiv gekühlt wird. Bei einem längeren Ausfall des Kompressors kann allerdings der Fall eintreten, dass das Helium komplett abgepumpt wird und dass MR-Magnetspulensystem quencht und sich erwärmt. Durch das Aufwärmen werden aus dem MR-Magnetspulensystem Gase im Vakuumbehälter freigesetzt. Diese Gase verschlechtern das Vakuum, was sich wiederum negativ auf die Wärmeisolation auswirkt. Ein zu schnelles und unkontrolliertes Aufwärmen droht. Um dies zu verhindern, wird frühzeitig die Kontrolleinheit aktiv, um das Absperrventil V3 zu öffnen und die Vakuumpumpe zu aktivieren, damit das Vakuum im Vakuumbehälter möglichst lange erhalten und damit der Wärmeeintrag auf das MR-Magnetspulensystem soweit verringert werden kann, dass ein unkontrolliertes Erwärmen des MR-Magnetspulensystems unterbunden wird.

4'. Der Drucksensor misst den aktuellen Druck $P_{ist}$ des Vakuumbehälters.

5'. Der Druck $P_{ist}$ wird an die Kontrolleinheit übermittelt und dort in der Prozessoreinheit mit einem vorgegebenen Drucksollwert $P1_{soll}$, der hier $10^{-3}$ mbar beträgt, verglichen. Wenn $P_{ist} < P1_{soll}$ wird die Kontrolleinheit aktiv. Die Kontrolleinheit aktiviert den Kaltkopf zum Kühlen des Kühlarms.
Über den Drucksollwert $P1_{soll}$ wird sichergestellt, dass ein ausreichend großes Vakuum im Vakuumbehälter herrscht und somit der Wärmeeintrag auf das MR-Magnetspulensystem verringert wird. Ist dieser Wert erreicht, wird der Kaltkopf wieder heruntergekühlt, um die MR-Apparatur wieder in Normalbetrieb nehmen zu können.

6'. Der Temperatursensor misst die aktuelle Temperatur $T_{ist}$ am MR-Magnetspulensystem.

7'. Die Temperatur $T_{ist}$ wird an die Kontrolleinheit übermittelt und dort in der Prozessoreinheit mit dem vorgegebenen Temperatursollwert $T1_{soll}$, verglichen. Wenn $T_{ist} < T1_{soll}$ wird die Kontrolleinheit aktiv. Die Kontrolleinheit schließt das Absperrventil V3 und deaktiviert die Vakuumpumpe.

8'. Der Temperatursensor misst weiterhin die aktuelle Temperatur $T_{ist}$ am MR-Magnetspulensystem. Die Temperatur $T_{ist}$ wird an die Kontrolleinheit übermittelt und dort in der Prozessoreinheit mit einem vorgegebenen Temperatursollwert $T2_{soll}$, der hier 4,2 K beträgt, verglichen. Wenn $T_{ist} \leq T2_{soll}$ wird die Kontrolleinheit aktiv. Die Kontrolleinheit übermittelt an den Kaltkopf, die Temperatur zu halten.

9'. Absperrventil V2 wird geschlossen und Absperrventil V1 wird geöffnet, um gasförmiges Helium dem Halsrohr wieder zuzuführen.
Die Temperatur $T_{ist}$ reicht aus, um das gasförmige Helium zu verflüssigen. Das flüssige Helium kühlt die MR-Magnetanordnung und die Verflüssigung läuft solange ab, bis das System im thermodynamischen Gleichgewicht ist.

10'. Alternativ kann bei einem Kaltkopfausfall die Kontrolleinheit die Vakuumpumpe wieder aktivieren und das Absperrventil V2 öffnen.

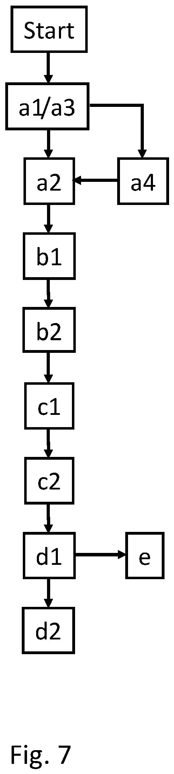

In **Fig. 7** ist ein schematisiertes Flussdiagramm mit den Verfahrensschritten gemäß der Ansprüche für Ausführungsformen mit drei Ventilen dargestellt.
Start: Die MR-Apparatur wird in Betrieb genommen.

a1/a3: Die aktuelle Temperatur $T_{ist}$ am MR-Magnetspulensystem wird gemessen und mit dem vorgebbaren ersten Temperatursollwert $T1_{soll}$ verglichen, ab dem der Vakuumbehälter ausgepumpt werden soll. Die aktuelle Temperatur $T_{ist}$ wird weiterhin mit dem vorgebbaren dritten Temperatursollwert $T3_{soll}$ verglichen.

a4: Wenn $T_{ist} > T3_{soll}$ wird die außerhalb des Vakuumbehälters angeordnete Vakuumpumpe aktiviert und das zweite Absperrventil V2 in der von der Vakuumpumpe zum Halsrohr führenden Vakuumleitung geöffnet.

a2: Wenn $T_{ist} > T1_{soll}$ wird die außerhalb des Vakuumbehälters angeordnete Vakuumpumpe aktiviert und das erste Absperrventil in der von der Vakuumpumpe in den Vakuumbehälter führenden Leitung geöffnet.

b1: Der aktuelle Druck $P_{ist}$ im Vakuumbehälter wird gemessen und mit einem vorgebbaren ersten Drucksollwert $P1_{soll}$ verglichen, bei dem das MR-Magnetspulensystem auf kryogene Temperatur heruntergekühlt werden soll.

b2: Wenn $P_{ist} < P1_{soll}$ wird der Kaltkopf zum Kühlen des Kühlarms aktiviert.

c1: Die aktuelle Temperatur $T_{ist}$ am MR-Magnetspulensystem wird gemessen und mit dem ersten Temperatursollwert $T1_{soll}$ verglichen.

c2: Wenn $T_{ist} < T1_{soll}$ wird das erste Absperrventil geschlossen und die Vakuumpumpe ausgeschalten.

d1: Die aktuelle Temperatur $T_{ist}$ am MR-Magnetspulensystem wird gemessen und mit dem zweiten Temperatursollwert $T2_{soll}$ verglichen, bei dem die Betriebstemperatur des MR-Magnetspulensystems für MR-Messungen erreicht ist. Der zweite Temperatursollwert $T2_{soll}$ wird beibehalten.

e: Helium wird in das Halsrohr zugeführt und verflüssigt.

d2: Bei Ausfall des Kaltkopfs wird flüssiges Helium im Halsrohr von der Vakuumpumpe abgepumpt, um das MR-Magnetspulensystem zu kühlen.

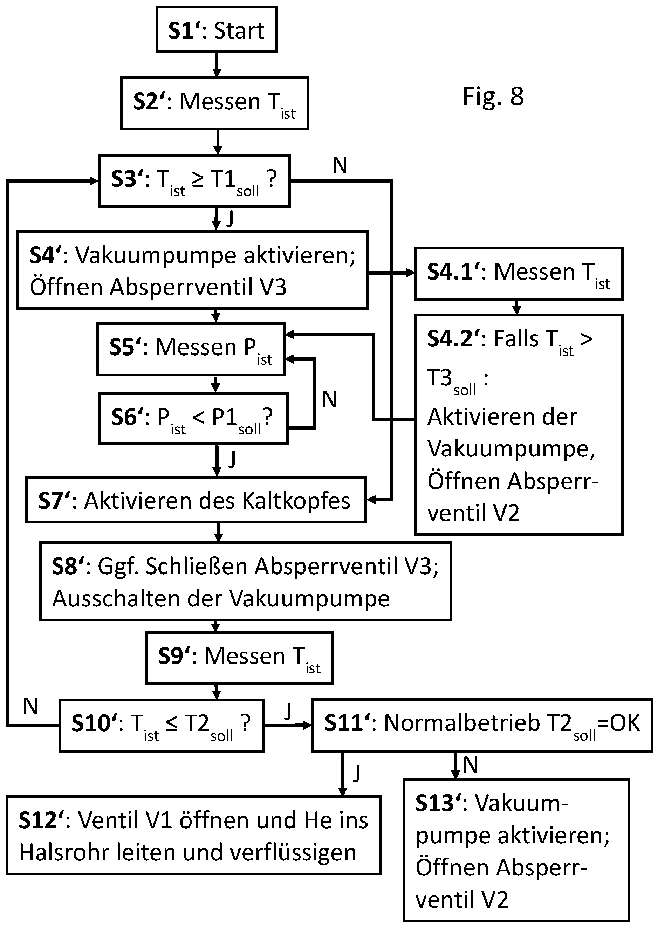

Der prinzipielle Ablauf des erfindungsgemäßen Abkühlverfahrens in Form eines Algorithmus, wie er in einem entsprechenden Programm in der Kontrolleinheit ablaufen soll, für Ausführungsformen mit drei Ventilen ist in **Fig. 8** als Flussdiagramm dargestellt.

Der Algorithmus lässt sich in folgende Schritte unterteilen:

S'1: Die Kontrolleinheit wird gestartet.

S'2: Der Temperatursensor des MR-Magnetspulensystems, der mit der Messeinheit verbunden ist, misst die aktuelle Temperatur $T_{ist}$.

S'3: Die Temperatur $T_{ist}$ wird in der Prozessoreinheit mit dem Wert $T1_{soll}$ verglichen und es wird geprüft, ob $T_{ist} \geq T1_{soll}$. Wenn die Prüfung negativ ausfällt, wird der Algorithmus bei S7' fortgesetzt. Wenn die Prüfung positiv ausfällt, aktiviert die Ansteuereinheit die Vakuumpumpe und öffnet das Absperrventil V3.

S'4: Die Ansteuereinheit aktiviert die Vakuumpumpe und öffnet das Absperrventil V3.

S'4.1: Der Temperatursensor des MR-Magnetspulensystems, der mit der Messeinheit verbunden ist, misst die aktuelle Temperatur $T_{ist}$.

S'4.2: Die Temperatur $T_{ist}$ wird in der Prozessoreinheit mit dem Wert $T3_{soll}$ verglichen und es wird geprüft, ob $T_{ist} > T3_{soll}$. Wenn die Prüfung positiv ausfällt, aktiviert die Ansteuereinheit die Vakuumpumpe und öffnet das Absperrventil V2.

S5': Der Drucksensor für den Vakuumbehälter, der mit der Messeinheit verbunden ist, misst den aktuellen Druck $P_{ist}$.

S6': Der Druck $P_{ist}$ wird in der Prozessoreinheit mit dem Wert $P1_{soll}$ verglichen und es wird geprüft, ob $P_{ist} < P1_{soll}$. Wenn die Prüfung negativ ausfällt, wird erneut der Druck $P_{ist}$ gemessen (und der Algorithmus wird bei S5' fortgesetzt). Wenn die Prüfung positiv ausfällt, aktiviert die Ansteuereinheit den Kaltkopf.

S7': Die Ansteuereinheit aktiviert den Kaltkopf.

S8': Die Ansteuereinheit schließt gegebenenfalls das Absperrventil V3 und das Absperrventil V2 und deaktiviert die Vakuumpumpe.

S9': Der Temperatursensor des MR-Magnetspulensystems, der mit der Messeinheit verbunden ist, misst die aktuelle Temperatur $T_{ist}$.

S10': Die Temperatur $T_{ist}$ wird in der Prozessoreinheit mit dem Wert $T2_{soll}$ verglichen und es wird geprüft, ob $T_{ist} \geq T2_{soll}$. Wenn die Prüfung negativ ausfällt, wird der Algorithmus bei S3' fortgesetzt. Wenn die Prüfung positiv ausfällt, wird der Algorithmus bei S11' fortgesetzt.

S1 1': Die Prozessoreinheit prüft, ob im Normalbetrieb $T2_{soll}$ = OK. Wenn die Prüfung positiv ausfällt, wird der Algorithmus bei S12' fortgesetzt. Wenn die Prüfung negativ ausfällt, wird der Algorithmus bei S13' fortgesetzt.

S12': Die Ansteuereinheit öffnet Ventil V1 und gasförmiges Helium wird ins Halsrohr geleitet und verflüssigt.

S13': Die Ansteuereinheit aktiviert die Vakuumpumpe und öffnet das Absperrventil V2.

**Bezugszeichenliste:**

| | |
|---|---|
| 10 | Magnetresonanz (="MR")-Apparatur |
| 11 | Vakuumbehälter |
| 12 | MR-Magnetspulensystem |
| 13 | Kryostat |
| 13a | Kompressor |
| 14 | Halsrohr |
| 15 | Außenmantel |
| 16 | Kühlarm |
| 17 | Kaltkopf |
| 18 | Hohlraum |
| 19 | kryogenes Fluid |
| 20 | Vakuumpumpe |
| 20a | Turbomolekularpumpe |
| 20b | Vorpumpe |
| 21 | Absperrventil (V3) |
| 22 | Vakuumleitung |
| 23 | Temperatursensor |
| 24 | erster Drucksensor |
| 25 | zweiter Drucksensor |
| 26 | Verbindungsleitung (vom Halsrohr zur Vakuumpumpe) |
| 27 | Absperrventil (V2) |
| 28 | Verbindungsleitung (von Heliumzufuhr zum Halsrohr) |
| 29 | Heliumzufuhr |
| 30 | Absperrventil (V1) |
| 40 | Kontrolleinheit |

## Referenzliste

Für die Beurteilung der Patentfähigkeit in Betracht gezogene Publikationen:

[0] DE 10 2016 218 000 B3 ≈ WO 2018/054648 A1 ≈ EP 3 488 451 B1 ≈ CN 109716457 B ≈ US 2019/212049 A1

[1] DE 10 2016 218 000 B3 ≈ WO 2018/054648 A1 ≈ EP 3 296 669 B1 ≈ CN 107845474 B ≈ JP 6338755 B ≈ US 10 101 420 B2

[2] DE 20 2017 001 501 U1

[3] EP 3 454 071 A1

[4] US 8 729 894 B2

[5] US 2006 0225433 A1

[6] DE 10 2014 218 773 B4 ≈ CN 105501679 B ≈ GB 2532322 B ≈ US 10 203 067 B2

[7] DE 10 2015 215 919 B4 ≈ GB 2542667 B ≈ US 10 203 068 B2

[8] JP 2020 145371 A

## Patentansprüche

1. Verfahren zum Betrieb einer Magnetresonanz(="MR")-Apparatur (10) mit einem in einem Vakuumbehälter (11) angeordneten, im MR-Messbetrieb trockenen (="Kryogen-freien"), supraleitfähigen MR-Magnetspulensystem (12) sowie mit einem Kryostaten (13) zum Kühlen des MR-Magnetspulensystems (12), welcher ein Halsrohr (14) umfasst, das durch einen Außenmantel (15) des Vakuumbehälters (11) hindurch zum MR-Magnetspulensystem (12) führt, wobei ein Kühlarm (16) eines Kaltkopfes (17) zumindest teilweise im Halsrohr (14) angeordnet ist, wobei um den Kühlarm (16) herum ein abgeschlossener Hohlraum (18) ausgebildet ist, der gegenüber dem zu kühlenden MR-Magnetspulensystem (12) fluiddicht abgedichtet und im Normalbetrieb der MR-Apparatur (10) zumindest teilweise mit einem kryogenen Fluid (19) gefüllt ist,
**gekennzeichnet durch folgende Schritte** zum autonomen Herunterkühlen des MR-Magnetspulensystems (12) auf eine kryogene Temperatur, bei der ein Laden des supraleitfähigen MR-Magnetspulensystems (12) mit Strom erfolgen kann:

   (a1) Messen der aktuellen Temperatur $T_{ist}$ am MR-Magnetspulensystem (12) und Vergleichen von $T_{ist}$ mit einem vorgebbaren ersten Temperatursollwert $T1_{soll}$, ab welchem der Vakuumbehälter (11) ausgepumpt werden soll;
   (a2) falls $T_{ist} > T1_{soll}$ Aktivieren einer außerhalb des Vakuumbehälters (11) angeordneten Vakuumpumpe (20) und Öffnen eines ersten Absperrventils (21) in einer von der Vakuumpumpe (20) in den Vakuumbehälter (11) führenden Vakuumleitung (22);

   (b1) Messen des aktuellen Drucks $P_{ist}$ im Vakuumbehälter (11) und Vergleichen von $P_{ist}$ mit einem vorgebbaren ersten Drucksollwert $P1_{soll}$, bei welchem das MR-Magnetspulensystem (12) auf kryogene Temperatur heruntergekühlt werden soll;
   (b2) falls $P_{ist} < P1_{soll}$ Aktivieren des Kaltkopfes (17) zum Kühlen des Kühlarms (16);
   (c1) Messen der aktuellen Temperatur $T_{ist}$ am MR-Magnetspulensystem (12) und Vergleichen von $T_{ist}$ mit dem ersten Temperatursollwert $T1_{soll}$;
   (c2) falls $T_{ist} < T1_{soll}$ Schließen des ersten Absperrventils (21) und
   Ausschalten der Vakuumpumpe (20);
   (d1) Weiterhin Messen der aktuellen Temperatur $T_{ist}$ am MR-Magnetspulensystem (12) und Vergleichen von $T_{ist}$ mit einem vorgebbaren zweiten Temperatursollwert $T2_{soll}$, bei welchem die Betriebstemperatur des MR-Magnetspulensystems (12) für MR-Messungen erreicht ist und nach Erreichen der Bedingung $T_{ist} \leq T2_{soll}$ Übermittlung der Information an den Kaltkopf (17), dass der zweite Temperatursollwert $T2_{soll}$ gehalten werden soll.

2. Verfahren nach Anspruch 1, **dadurch gekennzeichnet, dass** das Halsrohr (14) über ein erstes Ventil V1 (30) mit einer Heliumzufuhr (29) verbunden ist, wobei zeitlich nach Schritt (d1) in einem Schritt (e) Helium in das Halsrohr (14) zugeführt und verflüssigt wird.

3. Verfahren nach einem der vorhergehenden Ansprüche, **dadurch gekennzeichnet, dass** die Zufuhrleitung (26) zum Halsrohr (14) über ein weiteres Ventil V2 (27) mit der Vakuumpumpe (20) verbunden ist, und dass zeitlich nach Schritt (a2) und vor Schritt (b1) das Halsrohr (14) leergepumpt wird mit den Schritten

   (a3) Messen der aktuellen Temperatur $T_{ist}$ am MR-Magnetspulensystem (12) und Vergleichen von $T_{ist}$ mit einem vorgebbaren dritten Temperatursollwert $T3_{soll}$, ab welchem das Halsrohr (14) ausgepumpt werden soll; und
   (a4) falls $T_{ist} > T3_{soll}$ Aktivieren der Vakuumpumpe (20) und Öffnen des zweiten Absperrventils V2 (27) in einer von der Vakuumpumpe (20) zum Halsrohr (14) führenden Vakuumleitung (26).

4. Verfahren nach einem der vorhergehenden Ansprüche, **dadurch gekennzeichnet, dass** die vorgebbaren Temperatursollwerte $T1_{soll}$, $T2_{soll}$ und $T3_{soll}$ sowie der vorgebbare Drucksollwert $P1_{soll}$ aus folgenden Wertebereichen ausgewählt werden,

$$5K \leq T1_{soll} \leq 20K,$$

vorzugsweise etwa 8K;

$$3K \leq T2_{soll} \leq 5K,$$

vorzugsweise etwa 4,2K;

$$250K \leq T3_{soll} \leq 300K,$$

vorzugsweise etwa 280K

$$10^{-4}mbar \leq P1_{soll} \leq 10^{-1}mbar,$$

vorzugsweise etwa $10^{-3}$mbar.

5. Magnetresonanz(="MR")-Apparatur (10) zur Durchführung des Verfahrens nach einem der Ansprüche 1 bis 4,

mit einem in einem Vakuumbehälter (11) angeordneten, im MR-Messbetrieb trockenen(="Kryogen-freien"), supraleitfähigen MR-Magnetspulensystem (12) sowie mit einem Kryostaten (13) zum Kühlen des MR-Magnetspulensystems (12), welcher ein Halsrohr (14) umfasst, das durch einen Außenmantel (15) des Vakuumbehälters (11) hindurch zum MR-Magnetspulensystem (12) führt, wobei ein Kühlarm (16) eines Kaltkopfes (17) zumindest teilweise im Halsrohr (14) angeordnet ist, wobei um den Kühlarm (16) herum ein abgeschlossener Hohlraum (18) ausgebildet ist, der gegenüber dem zu kühlenden MR-Magnetspulensystem (12) fluiddicht abgedichtet und im Normalbetrieb der MR-Apparatur (10) zumindest teilweise mit einem kryogenen Fluid (19) gefüllt ist, **dadurch gekennzeichnet, dass** außerhalb des Vakuumbehälters (11) eine Vakuumpumpe (20) sowie ein erstes Absperrventil (21) in einer von der Vakuumpumpe (20) in den Vakuumbehälter (11) führenden Vakuumleitung (22) angeordnet sind,
dass ein Temperatursensor (23) zur Messung einer aktuellen Temperatur $T_{ist}$ am MR-Magnetspulensystem (12) sowie ein erster Drucksensor (24) zur Messung eines aktuellen Drucks $P_{ist}$ im Vakuumbehälter (11) vorhanden sind,
und **dass** eine Kontrolleinheit (40) zum Erfassen und Vergleichen der aktuellen Temperatur $T_{ist}$ am MR-Magnetspulensystem (12) mit vorgegebenen Temperatursollwerten, zum Erfassen und Vergleichen des aktuellen Drucks $P_{ist}$ im Vakuumbehälter (11) mit vorgegebenen Drucksollwerten sowie zur Ansteuerung des ersten Absperrventils (21), der Vakuumpumpe (20) und des Kaltkopfes (17) konfiguriert ist, wobei die Kontrolleinheit (40) Mittel enthält, die so angepasst sind, dass sie die Schritte des Verfahrens nach Anspruch 1 ausführen.

6. MR-Apparatur (10) nach Anspruch 5, **dadurch gekennzeichnet, dass** die Vakuumpumpe (20) mindestens 2stufig aufgebaut ist und eine Turbomolekularpumpe (20a) sowie eine Vorpumpe (20b) hierfür, vorzugsweise eine Membranpumpe, aufweist.

7. Kontrolleinheit (40) zur Durchführung des Verfahrens nach einem der Ansprüche 1 bis 4 zur Verwendung in einer MR-Apparatur (10) mit einem in einem Vakuumbehälter (11) angeordneten supraleitfähigen MR-Magnetspulensystem (12), mit einem Kryostaten (13) zum Kühlen des MR-Magnetspulensystems (12), welcher ein Halsrohr (14) umfasst, das durch einen Außenmantel (15) des Vakuumbehälters (11) hindurch zum MR-Magnetspulensystem (12) führt, wobei ein Kühlarm (16) eines Kaltkopfes (17) zumindest teilweise im Halsrohr (14) angeordnet ist, sowie mit einer außerhalb des Vakuumbehälters (11) angeordneten Vakuumpumpe (20) und einem ersten Absperrventil (21) in einer von der Vakuumpumpe (20) in den Vakuumbehälter (11) führenden Vakuumleitung (22), wobei die Kontrolleinheit (40) zum Erfassen und Vergleichen einer aktuellen Temperatur $T_{ist}$ am MR-Magnetspulensystem (12) mit vorgegebenen Temperatursollwerten, sowie zum Erfassen und Vergleichen eines aktuellen Drucks $P_{ist}$ im Vakuumbehälter (11) mit vorgegebenen Drucksollwerten konfiguriert ist,
**dadurch gekennzeichnet,**

dass die Kontrolleinheit (40) eine Messeinheit aufweist, an welche ein Temperatursensor (23) zur Messung der aktuellen Temperatur $T_{ist}$ am MR-Magnetspulensystem (12) sowie ein Drucksensor (24) zur Messung des aktuellen Drucks $P_{ist}$ im Vakuumbehälter (11) angeschlossen sind, dass die Kontrolleinheit (40) eine Ansteuereinheit zum Öffnen und Schließen des ersten Absperrventils (21), zur Aktivierung und Deaktivierung der Vakuumpumpe (20) sowie zur Aktivierung und Deaktivierung des Kaltkopfes (17) umfasst,
und **dass** die Kontrolleinheit (40) eine Prozessoreinheit enthält, die als Schnittstelle zwischen der Messeinheit und der Ansteuereinheit angeordnet ist zum Abgleich der erfassten Sensorparameter mit den Sollparametern und der Verarbeitung der Daten zur Ansteuerung von Kaltkopf (17), Vakuumpumpe (20) und Absperrventil (21).

8. Kontrolleinheit nach Anspruch 7, **dadurch gekenn-**

**zeichnet, dass** um den Kühlarm (16) herum ein abgeschlossener Hohlraum (18) ausgebildet ist, der gegenüber dem zu kühlenden MR-Magnetspulensystem (12) fluiddicht abgedichtet und im Normalbetrieb der MR-Apparatur (10) zumindest teilweise mit einem kryogenen Fluid (19) gefüllt ist, dass an die Messeinheit ein zweiter Drucksensor (25) zur Messung des aktuellen Drucks $P_{HR}$ in dem den Kühlarm (16) des Kaltkopfs (17) umgebenden Hohlraum (18) angeschlossen ist, und dass die Ansteuereinheit zum Öffnen und Schließen des zweiten und des dritten Absperrventils konfiguriert ist.

9. Kontrolleinheit nach Anspruch 8, **dadurch gekennzeichnet, dass** eine Verbindung (26) vom Halsrohr (14) zur Vakuumpumpe (20) vorhanden ist, und dass die Kontrolleinheit (40) die Steuerung von V2 (27) zur Vakuumpumpe (20) regelt.

10. Kontrolleinheit nach Anspruch 8 oder 9, **dadurch gekennzeichnet, dass** eine Verbindung (28) von einer Heliumzufuhr (29) zum Halsrohr (14) vorhanden ist, und dass die Kontrolleinheit (40) die Steuerung der He-Zufuhr (29) über das Ventil V1 (30) regelt.

**Claims**

1. A method of operating a magnetic resonance (= "MR") apparatus (10) having a superconductive MR magnetic coil system (12) which is disposed in a vacuum vessel (11) and is dry in MR measurement operation (= "cryogen-free") and having a cryostat (13) for cooling the MR magnetic coil system (12) which comprises a neck tube (14) that leads through an outer shell (15) of the vacuum vessel (11) to the MR magnetic coil system (12), wherein a cooling arm (16) of a cold head (17) is disposed at least partly within the neck tube (14), wherein a closed cavity (18) which is formed around the cooling arm (16) is sealed in a fluid-tight manner with respect to the MR magnetic coil system (12) to be cooled and is at least partly filled with a cryogenic fluid (19) in the normal operation of the MR apparatus (10), **characterized by the following steps** for autonomous cooling down of the MR magnetic coil system (12) to a cryogenic temperature at which the superconductive MR magnetic coil system (12) can be charged with current:

    (a1) measuring the current temperature $T_{ist}$ in the MR magnetic coil system (12) and comparing $T_{ist}$ with a definable first temperature target value $T1_{soll}$ from which the vacuum vessel (11) is to be pumped out;
    (a2) if $T_{ist} > T1_{soll}$, activating a vacuum pump (20) disposed outside the vacuum vessel (11) and opening a first barrier valve (21) in a vacuum conduit (22) that leads from the vacuum pump (20) into the vacuum vessel (11);
    (b1) measuring the current pressure $P_{ist}$ in the vacuum vessel (11) and comparing $P_{ist}$ with a definable first target pressure $P1_{soll}$ at which the MR magnetic coil system (12) is to be cooled down to cryogenic temperature;
    (b2) if $P_{ist} < P1_{soll}$, activating the cold head (17) for cooling of the cooling arm (16);
    (c1) measuring the current temperature $T_{ist}$ in the MR magnetic coil system (12) and comparing $T_{ist}$ with the first temperature target value $T1_{soll}$;
    (c2) if $T_{ist} < T1_{soll}$, closing the first barrier valve (21) and switching off the vacuum pump (20);
    (d1) further measuring the current temperature $T_{ist}$ in the MR magnetic coil system (12) and comparing $T_{ist}$ with a definable second temperature target value $T2_{soll}$ at which the operating temperature of the MR magnetic coil system (12) for MR measurements has been attained and when the condition $T_{ist} \leq T2_{soll}$ has been attained, transmitting the information to the cold head (17) that the second temperature target value $T2_{soll}$ shall be maintained.

2. The method as claimed in claim 1, **characterized in that** the neck tube (14) is connected via a first valve V1 (30) to a helium feed (29), wherein, in a step (e), helium is fed into the neck tube (14) and liquefied chronologically after step (d1).

3. The method as claimed in either of the preceding claims, **characterized in that** the feed conduit (26) to the neck tube (14) is connected via a further valve V2 (27) to the vacuum pump (20), and **in that** chronologically after step (a2) and prior to step (b1) the neck tube (14) is pumped dry by the steps of

    (a3) measuring the current temperature $T_{ist}$ in the MR magnetic coil system (12) and comparing $T_{ist}$ with a definable third temperature target value $T3_{soll}$ from which the neck tube (14) is to be pumped out; and
    (a4) if $T_{ist} > T3_{soll}$, activating the vacuum pump (20) and opening the second barrier valve V2 (27) in a vacuum conduit (26) that leads from the vacuum pump (20) to the neck tube (14).

4. The method as claimed in any of the preceding claims, **characterized in that** the definable temperature target values $T1_{soll}$, $T2_{soll}$ and $T3_{soll}$ and the definable pressure target value $P1_{soll}$ are selected from the following ranges of values:

$$5K \leq T1_{soll} \leq 20K,$$

preferably about 8K;

$$3K \leq T2_{soll} \leq 5K,$$

preferably about 4.2K;

$$250K \leq T3_{soll} \leq 300K,$$

preferably about 280K

$$10^{-4}mbar \leq P1_{soll} \leq 10^{-1}mbar,$$

preferably about $10^{-3}$mbar.

5. A magnetic resonance (= "MR") apparatus (10) for performing the method as claimed in any of claims 1 to 4,

having a superconductive MR magnetic coil system (12) which is disposed in a vacuum vessel (11) and is dry in MR measurement operation (= "cryogen-free") and having a cryostat (13) for cooling the MR magnetic coil system (12) which comprises a neck tube (14) that leads through an outer shell (15) of the vacuum vessel (11) to the MR magnetic coil system (12), wherein a cooling arm (16) of a cold head (17) is disposed at least partly within the neck tube (14), wherein a closed cavity (18) which is formed around the cooling arm (16) is sealed in a fluid-tight manner with respect to the MR magnetic coil system (12) to be cooled and is at least partly filled with a cryogenic fluid (19) in the normal operation of the MR apparatus (10), **characterized**
**in that** a vacuum pump (20) and a first barrier valve (21) are disposed outside the vacuum vessel (11) in a vacuum conduit (22) that leads from the vacuum pump (20) into the vacuum vessel (11),
**in that** a temperature sensor (23) for measuring a current temperature $T_{ist}$ in the MR magnetic coil system (12) and a first pressure sensor (24) for measuring a current pressure $P_{ist}$ are present in the vacuum vessel (11), and in that a control unit (40) is configured to detect and compare the current temperature $T_{ist}$ in the MR magnetic coil system (12) with defined temperature target values, to detect and compare the current pressure $P_{ist}$ in the vacuum vessel (11) with defined pressure target values, and to actuate the first barrier valve (21), the vacuum pump (20) and the cold head (17), wherein the control unit (40) contains means which are adjusted to perform the steps of the method according to claim 1.

6. The MR apparatus (10) as claimed in claim 5, **characterized in that** the vacuum pump (20) has an at least 2-stage construction and has a turbomolecular pump (20a) and a backing pump (20b) therefor, preferably a membrane pump.

7. A control unit (40) for performing the method as claimed in any of claims 1 to 4 for use in an MR apparatus (10), having a superconductive MR magnetic coil system (12) which is disposed in a vacuum vessel (11) and having a cryostat (13) for cooling the MR magnetic coil system (12) which comprises a neck tube (14) that leads through an outer shell (15) of the vacuum vessel (11) to the MR magnetic coil system (12), wherein a cooling arm (16) of a cold head (17) is disposed at least partly within the neck tube (14), and having a vacuum pump (20) disposed outside the vacuum vessel (11) and a first barrier valve (21) in a vacuum conduit (22) that leads from the vacuum pump (20) into the vacuum vessel (11), wherein the control unit (40) is configured to detect and compare a current temperature $T_{ist}$ in the MR magnetic coil system (12) with defined temperature target values, and to detect and compare a current pressure $P_{ist}$ in the vacuum vessel (11) with defined pressure target values, **characterized**

**in that** the control unit (40) has a measurement unit in which a temperature sensor (23) for measuring the current temperature $T_{ist}$ in the MR magnetic coil system (12) and a pressure sensor (24) for measuring the current pressure $P_{ist}$ in the vacuum vessel (11) are connected,
**in that** the control unit (40) comprises an actuation unit for opening and closing the first barrier valve (21), for activating and deactivating the vacuum pump (20) and for activating and deactivating the cold head (17), and in that the control unit (40) comprises a processor unit which is disposed as interface between the measurement unit and the actuation unit for comparison of the sensor parameters detected with the target parameters and the processing of the data for actuation of cold head (17), vacuum pump (20) and barrier valve (21).

8. The control unit as claimed in claim 7, **characterized in that** a closed cavity (18) is formed around the cooling arm (16), which is sealed in a fluid-tight manner with respect to the MR magnetic coil system (12) to be cooled and is at least partly filled with a cryogenic fluid (19) in the normal operation of the MR apparatus (10), **in that** a second pressure sensor (25) for measuring the current pressure $P_{HR}$ in the cavity (18) surrounding the cooling arm (16) of the cold head (17) is connected to the measurement unit, and **in that** the actuation unit is configured to open and close the second and third barrier valves.

**9.** The control unit as claimed in claim 8, **characterized in that** there is a connection (26) from the neck tube (14) to the vacuum pump (20), and **in that** the control unit (40) implements the control of V2 (27) to the vacuum pump (20).

**10.** The control unit as claimed in claim 8 or 9, **characterized in that** there is a connection (28) from a helium feed (29) to the neck tube (14), and **in that** the control unit (40) implements the control of the He feed (29) via the valve V1 (30).

**Revendications**

**1.** Procédé de fonctionnement d'un appareil à résonance magnétique(=« RM ») (10) comprenant un système de bobines magnétiques RM supraconducteur (12), à sec (=« sans cryogène ») en mode de mesure RM, agencé dans un réservoir sous vide (11), et comprenant un cryostat (13) qui permet de refroidir le système de bobines magnétiques RM (12) et qui comprend un tube à collet (14) menant au système de bobines magnétiques RM (12) en passant à travers une enveloppe extérieure (15) du réservoir sous vide (11), un bras de refroidissement (16) d'une tête froide (17) étant agencé au moins partiellement dans le tube à collet (14), une cavité fermée (18) étanche aux fluides par rapport au système de bobines magnétiques RM (12) à refroidir et remplie au moins partiellement d'un fluide cryogénique (19) en fonctionnement normal de l'appareil RM (10) étant formée autour du bras de refroidissement (16), **caractérisé par** les étapes ci-dessous en vue d'un refroidissement autonome du système de bobines magnétiques RM (12) à une température cryogénique à laquelle une charge du système de bobines magnétiques RM supraconducteur (12) avec du courant peut intervenir :

(a1) mesurer la température actuelle $T_{ist}$ au niveau du système de bobines magnétiques RM (12) et comparer $T_{ist}$ avec une première valeur de consigne de température $T1_{soll}$ prédéfinissable à partir de laquelle le réservoir sous vide (11) doit être pompé ;
(a2) si $T_{ist} > T1_{soll}$, activer une pompe à vide (20) agencée à l'extérieur du réservoir sous vide (11) et ouvrir une première vanne d'arrêt (21) dans une conduite à vide (22) menant de la pompe à vide (20) au réservoir sous vide (11) ;
(b1) mesurer la pression actuelle $P_{ist}$ dans le réservoir sous vide (11) et comparer $P_{ist}$ avec une première valeur de consigne de pression $P1_{soll}$ prédéfinissable à laquelle le système de bobines magnétiques RM (12) doit être refroidi à la température cryogénique ;
(b2) si $P_{ist} < P1_{soll}$, activer la tête froide (17) afin de refroidir le bras de refroidissement (16) ;
(c1) mesurer la température actuelle $T_{ist}$ au niveau du système de bobines magnétiques RM (12) et comparer $T_{ist}$ avec la première valeur de consigne de température $T1_{soll}$ ;
(c2) si $T_{ist} < T1_{soll}$, fermer la première vanne d'arrêt (21) et désactiver la pompe à vide (20) ;
(d1) mesurer en outre la température actuelle $T_{ist}$ au niveau du système de bobines magnétiques RM (12) et comparer $T_{ist}$ avec une seconde valeur de consigne de température $T2_{soll}$ prédéfinissable à laquelle la température de fonctionnement du système de bobines magnétiques RM (12) est atteinte pour les mesures RM et, après avoir atteint la condition $T_{ist} \leq T2_{soll}$, transmettre à la tête froide (17) l'information selon laquelle la seconde valeur de consigne de température $T2_{soll}$ doit être maintenue.

**2.** Procédé selon la revendication 1, **caractérisé en ce que** le tube à collet (14) est relié à une alimentation en hélium (29) par l'intermédiaire d'une première vanne V1 (30), de l'hélium étant introduit et liquéfié dans le tube à collet (14) dans une étape (e) située chronologiquement après l'étape (d1).

**3.** Procédé selon l'une quelconque des revendications précédentes, **caractérisé en ce que** la conduite d'alimentation (26) menant vers le tube à collet (14) est reliée à la pompe à vide (20) par l'intermédiaire d'une vanne V2 (27) supplémentaire, et **en ce que**, chronologiquement après l'étape (a2) et avant l'étape (b1), le tube à collet (14) est pompé à vide avec les étapes consistant à

(a3) mesurer la température actuelle Tist au niveau du système de bobines magnétiques RM (12) et comparer Tist avec une première valeur de consigne de température $T3_{soll}$ prédéfinissable à partir de laquelle le réservoir sous vide (14) doit être pompé ;
(a4) si $T_{ist} > T3_{soll}$, activer la pompe à vide (20) et ouvrir la deuxième vanne d'arrêt V2 (27) dans une conduite à vide (26) menant de la pompe à vide (20) au tube à collet (14).

**4.** Procédé selon l'une quelconque des revendications précédentes, **caractérisé en ce que** les valeurs de consigne de température $T1_{soll}$, $T2_{soll}$ et $T3_{soll}$ prédéfinissables ainsi que la valeur de consigne de pression $P1_{soll}$ prédéfinissable sont sélectionnées parmi les plages de valeurs ci-dessous :

$$5K \leq T1_{soll} \leq 20K,$$

de manière préférée environ 8K ;

$$3K \leq T2_{soll} \leq 5K,$$

de manière préférée environ 4,2K ;

$$250K \leq T3_{soll} \leq 300K,$$

de manière préférée environ 280K ;

$$10^{-4}mbar \leq P1_{soll} \leq 10^{-1}mbar,$$

de manière préférée environ $10^{-3}$mbar.

5. Appareil à résonance magnétique(="RM") (10) permettant la mise en oeuvre du procédé selon l'une quelconque des revendications 1 à 4,

comprenant un système de bobines magnétiques RM supraconducteur (12), à sec en mode de mesure RM (=« sans cryogène »), agencé dans un réservoir sous vide (11), et comprenant un cryostat (13) qui permet de refroidir le système de bobines magnétiques RM (12) et qui comprend un tube à collet (14) menant au système de bobines magnétiques RM (12) en passant à travers une enveloppe extérieure (15) du réservoir sous vide (11), un bras de refroidissement (16) d'une tête froide (17) étant agencé au moins partiellement dans le tube à collet (14), une cavité fermée (18) étanche aux fluides par rapport au système de bobines magnétiques RM (12) à refroidir et remplie au moins partiellement d'un fluide cryogénique (19) en fonctionnement normal de l'appareil RM (10) étant formée autour du bras de refroidissement (16), **caractérisé en ce que**

à l'extérieur du réservoir sous vide (11), une pompe à vide (20) et une première vanne d'arrêt (21) sont agencées dans une conduite à vide (22) menant de la pompe à vide (20) au réservoir sous vide (11),

un capteur de température (23) permettant de mesurer une température actuelle $T_{ist}$ au niveau du système de bobines magnétiques RM (12) et un premier capteur de pression (24) permettant de mesurer une pression actuelle $P_{ist}$ sont présents dans le réservoir sous vide (11),

et une unité de contrôle (40) est configurée pour détecter et comparer la température actuelle $T_{ist}$ au niveau du système de bobines magnétiques RM (12) avec des valeurs de consigne de température prédéfinies, pour détecter et comparer la pression actuelle $P_{ist}$ dans le réservoir sous vide (11) avec des valeurs de consigne de pression prédéfinies, et pour commander la première vanne d'arrêt (21), la pompe à vide (20) et la tête froide (17), sachant que l'unité de contrôle (40) comprend des moyens appropriés pour mettre en oeuvre les étapes du procédé selon la revendication 1.

6. Appareil RM (10) selon la revendication 5, **caractérisé en ce que** la pompe à vide (20) est construite en au moins 2 étapes et présente une pompe turbomoléculaire (20a) et une pompe primaire (20b) destinée à celle-ci, de manière préférée une pompe à membrane.

7. Unité de contrôle (40) permettant la mise en oeuvre du procédé selon l'une quelconque des revendications 1 à 4 en vue d'une utilisation dans un appareil RM (10) comprenant un système de bobines magnétiques RM supraconducteur (12) agencé dans un réservoir sous vide (11), et comprenant un cryostat (13) qui permet de refroidir le système de bobines magnétiques RM (12) et qui comprend un tube à collet (14) menant au système de bobines magnétiques RM (12) en passant à travers une enveloppe extérieure (15) du réservoir sous vide (11), un bras de refroidissement (16) d'une tête froide (17) étant agencé au moins partiellement dans le tube à collet (14), et comprenant une pompe à vide (20) agencée à l'extérieur du réservoir sous vide (11) et une première vanne d'arrêt (21) dans une conduite à vide (22) menant de la pompe à vide (20) au réservoir sous vide (11), l'unité de contrôle (40) étant configurée pour détecter et comparer une température actuelle $T_{ist}$ au niveau du système de bobines magnétiques RM (12) avec des valeurs de consigne de température prédéfinies, et pour détecter et comparer une pression actuelle $P_{ist}$ dans le réservoir sous vide (11) avec des valeurs de consigne de pression prédéfinies,
**caractérisée en ce que**

l'unité de contrôle (40) présente une unité de mesure au niveau de laquelle sont raccordés un capteur de température (23) permettant de mesurer la température actuelle $T_{ist}$ au niveau du système de bobines magnétiques RM (12) et un capteur de pression (24) permettant de mesurer la pression actuelle $P_{ist}$ dans le réservoir sous vide (11), **en ce que** l'unité de contrôle (40) comprend une unité de commande permettant d'ouvrir et de fermer la première vanne d'arrêt (21), d'activer et de désactiver la pompe à vide (20), et d'activer et de désactiver la tête froide (17),
et **en ce que** l'unité de contrôle (40) contient une unité de processeur qui est agencée sous forme d'interface entre l'unité de mesure et l'unité de commande afin de faire correspondre les paramètres de capteur détectés aux paramètres de consigne et au traitement des données en vue de la commande de la tête froide (17), de la pompe à vide (20) et de la vanne d'arrêt (21).

8. Unité de contrôle selon la revendication 7, **caractérisée en ce qu'**une cavité fermée (18) est formée autour du bras de refroidissement (16), qui est étanche aux fluides par rapport au système de bobines magnétiques RM (12) à refroidir et qui est remplie au moins partiellement d'un fluide cryogénique (19) en fonctionnement normal de l'appareil RM (10), **en ce qu'**un deuxième capteur de pression (25) est raccordé à l'unité de mesure afin de mesurer la pression actuelle $P_{HR}$ dans la cavité (18) entourant le bras de refroidissement (16) de la tête froide (17), et **en ce que** l'unité de commande est configurée pour ouvrir et fermer les deuxième et troisième vannes d'arrêt.

9. Unité de contrôle selon la revendication 8, **caractérisée en ce qu'**une liaison (26) est présente entre le tube à collet (14) et la pompe à vide (20), et **en ce que** l'unité de contrôle (40) régule la commande de V2 (27) vers la pompe à vide (20).

10. Unité de contrôle selon la revendication 8 ou 9, **caractérisée en ce qu'**une liaison (28) est présente entre une alimentation en hélium (29) et le tube à collet (14), et **en ce que** l'unité de contrôle (40) régule la commande de l'alimentation en He (29) par l'intermédiaire de la vanne V1 (30).

Fig. 1

1.:Start

2.:Messen $T_{ist}$

3.: Falls $T_{ist} \geq T1_{soll}$ :
Vakuumpumpe aktivieren;
Öffnen Absperrventil V3

4.: Messen $P_{ist}$

5.: Falls $P_{ist} < P1_{soll}$:
Aktivieren des Kaltkopfes

6.: Messen $T_{ist}$

7.: Falls $T_{ist} < T1_{soll}$ :
Schließen Absperrventil V3,
Ausschalten der Vakuumpumpe

8.: Messen $T_{ist}$ ,
falls $T_{ist} \leq T2_{soll}$ , beibehalten $T2_{soll}$

9.: Zufuhr von He in Halsrohr

Fig. 2

Fig. 3

**S1**: Start

**S2**: Messen $T_{ist}$

**S3**: $T_{ist} \geq T1_{soll}$ ?  N

J

**S4**: Vakuumpumpe aktivieren; Öffnen Absperrventil V3

**S5**: Messen $P_{ist}$  N

**S6**: $P_{ist} < P1_{soll}$?

J

**S7**: Aktivieren des Kaltkopfes

**S8**: Ggf. Schließen Absperrventil V3; Ausschalten der Vakuumpumpe

**S9**: Messen $T_{ist}$

N  **S10**: $T_{ist} \leq T2_{soll}$ ?  J  **S11**: Beibehalten $T2_{soll}$

Fig. 4

Fig. 5

**1'.: Start**

**2'.: Messen** $T_{ist}$

**3.1'.: Falls** $T_{ist}$ **>** $T3_{soll}$ **: Vakuumpumpe aktivieren; Öffnen Absperrventil V2**

**3'.: Falls** $T_{ist} \geq T1_{soll}$ **: Vakuumpumpe aktivieren; Öffnen Absperrventil V3**

**4'.: Messen** $P_{ist}$

**5'.: Falls** $P_{ist} < P1_{soll}$**: Aktivieren des Kaltkopfes**

**6'.: Messen** $T_{ist}$

**7'.: Falls** $T_{ist} < T1_{soll}$ **: Schließen Absperrventil V3, Ausschalten der Vakuumpumpe**

**8'.: Messen** $T_{ist}$**, falls** $T_{ist} \leq T2_{soll}$**, beibehalten** $T2_{soll}$

**9'.: Zufuhr von He in Halsrohr**

**10'.: Bei Kaltkopfausfall: Vakuumpumpe aktivieren, Öffnen Absperrventil V2**

Fig. 6

Fig. 7

Fig. 8

S1': Start

S2': Messen $T_{ist}$

S3': $T_{ist} \geq T1_{soll}$ ?  N

J

S4': Vakuumpumpe aktivieren; Öffnen Absperrventil V3

S4.1': Messen $T_{ist}$

S4.2': Falls $T_{ist} > T3_{soll}$ : Aktivieren der Vakuumpumpe, Öffnen Absperrventil V2

S5': Messen $P_{ist}$

S6': $P_{ist} < P1_{soll}$?  N

J

S7': Aktivieren des Kaltkopfes

S8': Ggf. Schließen Absperrventil V3; Ausschalten der Vakuumpumpe

S9': Messen $T_{ist}$

N  S10': $T_{ist} \leq T2_{soll}$ ?  J  S11': Normalbetrieb $T2_{soll}$=OK

J  N

S12': Ventil V1 öffnen und He ins Halsrohr leiten und verflüssigen

S13': Vakuumpumpe aktivieren; Öffnen Absperrventil V2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2019212049 A1
- DE 102016218000 B3
- DE 202017001501 U1
- EP 3454071 A1
- US 8729894 B2
- US 20060225433 A1
- DE 102014218773 B4
- DE 102015215919 B4
- JP 2020145371 A
- WO 2018054648 A1
- EP 3488451 B1
- CN 109716457 B
- EP 3296669 B1
- CN 107845474 B
- JP 6338755 B
- US 10101420 B2
- CN 105501679 B
- GB 2532322 B
- US 10203067 B2
- GB 2542667 B
- US 10203068 B2